# EUROPEAN PATENT SPECIFICATION

(11) **EP 2 275 871 B1**
(45) Date of publication and mention of the grant of the patent: **27.06.2018**
(21) Application number: 10169673.0
(22) Date of filing: 15.07.2010
(51) Int. Cl.: G03F 9/00

(54) **Position Calibration of Alignment Heads in a Multi-Head Alignment System**
Positionskalibrierung von Ausrichtungsköpfen in einem Mehrfach-Kopf-Ausrichtungssystem
Étalonnage de la position de têtes d'alignement dans un système d'alignement à plusieurs têtes

(30) Priority: 16.07.2009 US 226102 P
(43) Date of publication of application: 19.01.2011
(73) Proprietor: ASML Netherlands B.V., 5504 DR Veldhoven (NL)
(72) Inventor: Kaneko, Takeshi, 5211 AM 's-Hertogenbosch (NL); Compen, Rene, 5554 AJ Valkenswaard (NL)
(74) Representative: van Os, Lodewijk Hubertus

(56) References cited:
- EP-A1- 2 003 680

## Description

### FIELD

The present invention relates to position calibration of alignment heads in a multi-head alignment system, and in particular to robust position calibration of secondary alignment heads with a primary alignment head in a multi-head alignment system.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatus include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti parallel to this direction. It is also possible to transfer the pattern from the patterning device to the substrate by imprinting the pattern onto the substrate.

In order to monitor the lithographic process, it is necessary to measure parameters of the patterned substrate, for example the overlay error between successive layers formed in or on it. There are various techniques for making measurements of the microscopic structures formed in lithographic processes, including the use of scanning electron microscopes and various specialized tools. One form of specialized inspection tool is a scatterometer in which a beam of radiation is directed onto a target on the surface of the substrate and properties of the scattered or reflected beam are measured. By comparing the properties of the beam before and after it has been reflected or scattered by the substrate, the properties of the substrate can be determined. This can be done, for example, by comparing the reflected beam with data stored in a library of known measurements associated with known substrate properties. Two main types of scatterometer are known. Spectroscopic scatterometers direct a broadband radiation beam onto the substrate and measure the spectrum (intensity as a function of wavelength) of the radiation scattered into a particular narrow angular range. Angularly resolved scatterometers use a monochromatic radiation beam and measure the intensity of the scattered radiation as a function of angle.

Before exposure by a lithographic apparatus, a wafer has to be measured and aligned, for the accurate placement of a pattern on the surface, for example to ensure correct overlay between successive patterned layers. It is known to provide multiple alignment sensors, as described for example in US 2008/0088843, hereby incorporated by reference. The multiple alignment heads are used to measure a number of alignment marks in parallel, that is, taking two or more measurements as part of the same measurement step, to improve throughput. However, with multiple alignment heads calibration of the alignment head system becomes difficult, because for example, the calibration of the secondary alignment heads with respect to the primary alignment head may be inaccurate, for example because of defective marks or low signal-to-noise ration. Therefore, improvements are needed to improve calibration of multiple alignment heads, to improve overlay accuracy and product yield.

EP2003680A1 discloses a primary alignment system and four secondary alignment systems and a method of measuring different alignment marks by the four secondary alignment systems.

### SUMMARY

According to a first aspect of the present disclosure there is provided a method of calibrating one or more secondary alignment heads with one or more primary alignment heads, wherein the primary alignment head measures an alignment mark; at least one secondary alignment head measures the same alignment mark; and the offset of the secondary alignment head with respect to the primary alignment head is derived from the measurements made on that alignment mark, wherein the one or more primary alignment heads measure at least two alignment marks in common with each of the at least one secondary alignment head.

According to a second aspect of the present disclosure there is provided a method of wafer alignment, performed as preparation for a lithographic process, wherein the wafer is measured by an alignment system that comprises a primary alignment system comprising a primary alignment head and a secondary alignment system comprising one or more secondary alignment heads; the method comprising performing a primary baseline calibration to align the primary alignment head with respect to a reference object; performing a secondary baseline calibration to align the secondary alignment heads with respect to the primary alignment head; and calibrating one or more secondary alignment heads with respect to the primary alignment head, wherein: the primary alignment head measures an alignment mark; at least one secondary alignment head measures the same alignment mark; and the offset of the secondary alignment head with respect to the primary alignment head is derived from the measurements made on that alignment mark, wherein the one or more primary alignment heads measure at least two alignment marks in common with each of the at least one secondary alignment head.

According to a third aspect of the present disclosure there is provided calibration apparatus comprising an alignment system comprising a primary alignment system comprising a primary alignment head and a sensor for detecting an alignment mark; a secondary alignment system comprising one or more secondary alignment heads, each comprising a sensor for detecting an alignment mark; a mechanism for moving the alignment system between a first position in which the primary alignment head measures an alignment mark; and a second position in which a secondary alignment head measures the same alignment mark; an encoder for measuring the position of the alignment system; and a processor for receiving measurements from the alignment system sensors and position information from the mechanism for moving the alignment system; and calculating from the measurements the offset of the secondary alignment head with respect to the primary alignment head, wherein the one or more primary alignment heads measure at least two alignment marks in common with each of the at least one secondary alignment head.

According to a fourth aspect of the present disclosure there is provided a lithographic apparatus comprising calibration apparatus comprising an alignment system comprising a primary alignment system comprising a primary alignment head and a sensor for detecting an alignment mark; a secondary alignment system comprising one or more secondary alignment heads, each comprising a sensor for detecting an alignment mark; a mechanism for: moving the alignment system between measurement positions to perform a primary baseline calibration to align the primary alignment head with respect to a reference object, and a secondary baseline calibration to align the secondary alignment heads with respect to the primary alignment head; and for moving the alignment system between a first position in which the primary alignment head measures an alignment mark; and a second position in which a secondary alignment head measures the same alignment mark; an encoder for measuring the position of the alignment system; and a processor for receiving measurements from the alignment system sensors and position information from the mechanism for moving the alignment system; and calculating from the measurements the offset of the secondary alignment head with respect to the primary alignment head, wherein the one or more primary alignment heads measure at least two alignment marks in common with each of the at least one secondary alignment head.

According to a fifth aspect of the present disclosure there is provided a computer program product, that, when executed on a computer, provides instructions for carrying out a method of calibrating one or more secondary alignment heads with one or more primary alignment heads, wherein the primary alignment head measures an alignment mark; at least one secondary alignment head measures the same alignment mark; and the offset of the secondary alignment head with respect to the primary alignment head is derived from the measurements made on that alignment mark, wherein the one or more primary alignment heads measure at least two alignment marks in common with each of the at least one secondary alignment head.

According to a sixth aspect of the present disclosure there is provided a computer program product, that, when executed on a computer, provides instructions for carrying out a method of wafer alignment, performed as preparation for a lithographic process, wherein the wafer is measured by an alignment system that comprises a primary alignment system comprising a primary alignment head and a secondary alignment system comprising one or more secondary alignment heads; the method comprising performing a primary baseline calibration to align the primary alignment head with respect to a reference object; performing a secondary baseline calibration to align the secondary alignment heads with respect to the primary alignment head; and calibrating one or more secondary alignment heads with respect to the primary alignment head, wherein: the primary alignment head measures an alignment mark; at least one secondary alignment head measures the same alignment mark; and the offset of the secondary alignment head with respect to the primary alignment head is derived from the measurements made on that alignment mark, wherein the one or more primary alignment heads measure at least two alignment marks in common with each of the at least one secondary alignment head.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Figure 1 depicts a lithographic apparatus;
Figure 2 depicts a lithographic cell or cluster;
Figure 3 depicts a first scatterometer;
Figure 4 depicts a second scatterometer;
Figure 5 depicts a first example of a stage unit;
Figure 6 shows a second example of a stage unit;
Figure 7 shows a first example of an encoder system, in which a diffraction grating is provided on a metrology frame and a sensor is provided on a wafer stage;
Figure 8 shows a second example of an encoder system; in which a diffraction grating is provided on a wafer stage and a sensor is provided on a metrology frame;
Figure 9 shows a schematic plan view of a multiple alignment head system; Figure 10 shows the multiple head alignment system of figure 9 attached to an encoder system;
Figure 11 depicts an initial position in an alignment operation;
Figure 12 shows a subsequent step in an alignment operation;
Figure 13 illustrates the depth of focus of alignment heads with respect to an uneven surface;
Figure 14 shows a first step of a primary alignment system calibration procedure;
Figure 15 shows a second stage of a primary alignment system calibration procedure;
Figure 16 shows a first step of a secondary alignment system calibration procedure;
Figure 17 shows a second step of a secondary alignment system calibration procedure;
Figure 18 shows a series of steps carried out in an embodiment of a secondary alignment head calibration procedure;
Figure 19 shows the measurements made in the series of steps carried out in an embodiment of a secondary alignment head calibration procedure as shown in Figure 18; and
Figure 20 shows a series of measurements made in an embodiment of a secondary alignment head calibration procedure, comprising the steps of Figure 19 together with additional steps, and representing all possible steps for an alignment system that comprises five alignment heads and five alignment marks.

### DETAILED DESCRIPTION

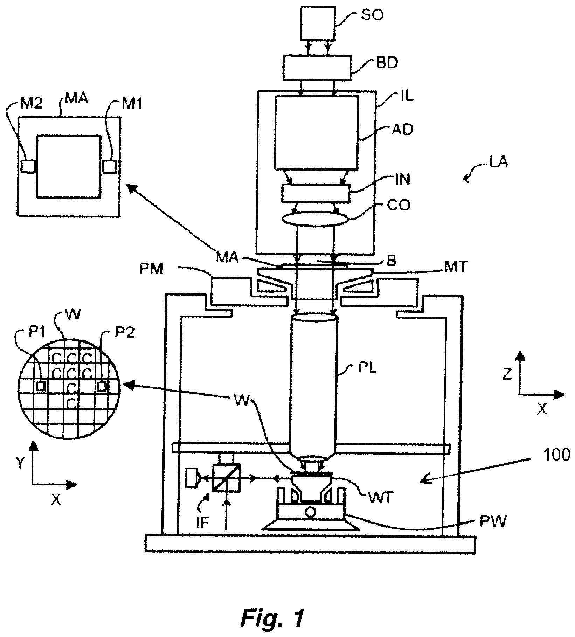

Figure 1 schematically depicts a lithographic apparatus. The apparatus comprises:
- an illumination system (illuminator) IL configured to condition a radiation beam B (e.g. UV radiation or DUV radiation).
- a support structure (e.g. a mask table) MT constructed to support a patterning device (e.g. a mask) MA and connected to a first positioner PM configured to accurately position the patterning device in accordance with certain parameters
- a stage unit 100 comprising at least one substrate table (e.g. a wafer table) WT constructed to hold a substrate (e.g. a resist coated wafer) W, and, optionally, a measurement table comprising various sensors. The stage unit also comprises various components for moving and controlling the substrate table(s) and/or measurement table (Fig. 1 shows a second positioner PW configured to accurately position the substrate held by the substrate table WT in accordance with certain parameters). In the following description the terms "stage" and "table" can generally be used interchangeably unless the specific context otherwise dictates. The apparatus further comprises
- a projection system (e.g. a refractive projection lens system) PL configured to project a pattern imparted to the radiation beam B by patterning device MA onto a target portion C (e.g. comprising one or more dies) of the substrate W.

The illumination system may include various types of optical components, such as refractive, reflective, magnetic, electromagnetic, electrostatic or other types of optical components, or any combination thereof, for directing, shaping, or controlling radiation.

The support structure supports, i.e. bears the weight of, the patterning device. It holds the patterning device in a manner that depends on the orientation of the patterning device, the design of the lithographic apparatus, and other conditions, such as for example whether or not the patterning device is held in a vacuum environment. The support structure can use mechanical, vacuum, electrostatic or other clamping techniques to hold the patterning device. The support structure may be a frame or a table, for example, which may be fixed or movable as required. The support structure may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

As here depicted, the apparatus is of a transmissive type (e.g. employing a transmissive mask). Alternatively, the apparatus may be of a reflective type (e.g. employing a programmable mirror array of a type as referred to above, or employing a reflective mask).

The stage unit 100 provided as part of the lithographic apparatus LA can have various different configurations. In one configuration, the lithographic apparatus may be of a type having one substrate table WT and one measurement table. In an alternative embodiment, the lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein at least a portion of the substrate may be covered by a liquid having a relatively high refractive index, e.g. water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may comprise an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may comprise various other components, such as an integrator IN and a condenser CO. The illuminator may be used to condition the radiation beam, to have a desired uniformity and intensity distribution in its cross section.

The radiation beam B is incident on the patterning device (e.g., mask MA), which is held on the support structure (e.g., mask table MT), and is patterned by the patterning device. Having traversed the mask MA, the radiation beam B passes through the projection system PL, which focuses the beam onto a target portion C of the substrate W. With the aid of the second positioner PW and position sensor IF (e.g. an interferometric device, linear encoder, 2-D encoder or capacitive sensor), the substrate table WT can be moved accurately, e.g. so as to position different target portions C in the path of the radiation beam B. Similarly, the first positioner PM and another position sensor (which is not explicitly depicted in Figure 1) can be used to accurately position the mask MA with respect to the path of the radiation beam B, e.g. after mechanical retrieval from a mask library, or during a scan. In general, movement of the mask table MT may be realized with the aid of a long-stroke module (coarse positioning) and a short-stroke module (fine positioning), which form part of the first positioner PM. Similarly, movement of the substrate table WT may be realized using a long-stroke module and a short-stroke module, which form part of the second positioner PW. In the case of a stepper (as opposed to a scanner) the mask table MT may be connected to a short-stroke actuator only, or may be fixed. Mask MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the mask MA, the mask alignment marks may be located between the dies.

The depicted apparatus could be used in at least one of the following modes:
1. In step mode, the mask table MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the radiation beam is projected onto a target portion C (i.e. a single dynamic exposure). The velocity and direction of the substrate table WT relative to the mask table MT may be determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning device, and the substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

Combinations and/or variations on the above described modes of use or entirely different modes of use may also be employed.

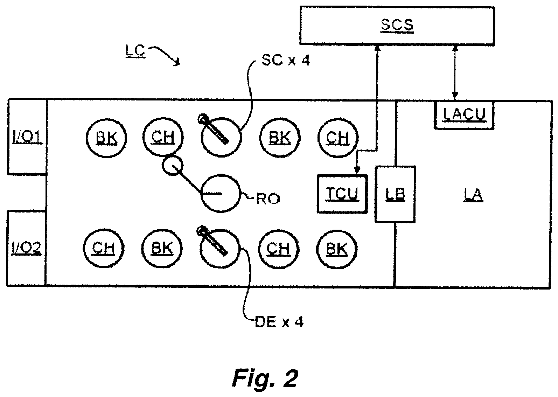

As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers them to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. If errors are detected, adjustments may be made to exposures of subsequent substrates, especially if the inspection can be done soon and fast enough that other substrates of the same batch are still to be exposed. Also, already exposed substrates may be stripped and reworked - to improve yield - or discarded, thereby avoiding performing exposures on substrates that are known to be faulty. In a case where only some target portions of a substrate are faulty, further exposures can be performed only on those target portions which are good.

An inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

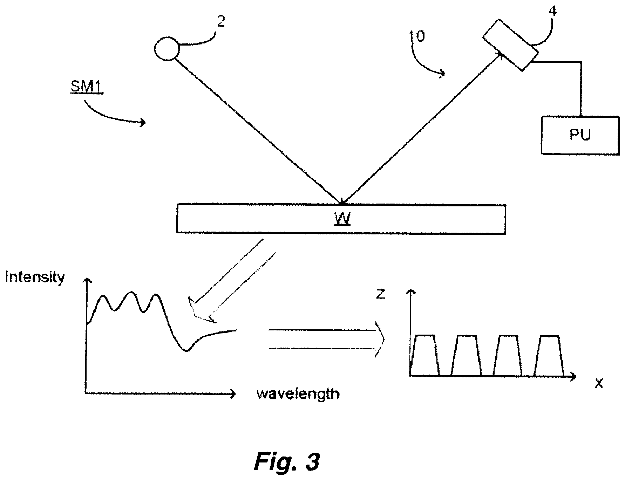

Figure 3 depicts a scatterometer which may be used in the present invention. It comprises a broadband (white light) radiation projector 2 which projects radiation onto a substrate W. The reflected radiation is passed to a spectrometer detector 4, which measures a spectrum 10 (intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

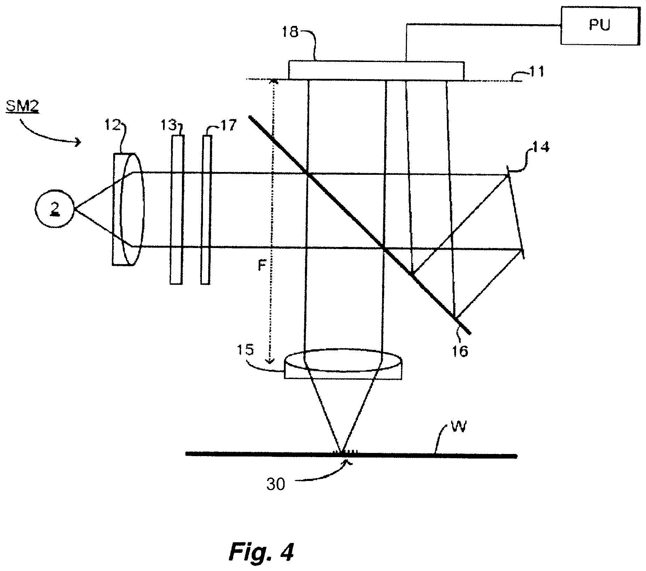

Another scatterometer that may be used with the present invention is shown in Figure 4. In this device, the radiation emitted by radiation source 2 is focused using lens system 12 through interference filter 13 and polarizer 17, reflected by partially reflected surface 16 and is focused onto substrate W via a microscope objective lens 15 . The reflected radiation then transmits through a partially reflective surface 16 into a detector 18 in order to have the scatter spectrum detected. The detector may be located in the back-projected pupil plane 11, which is at the focal length of the lens system 15, however the pupil plane may instead be re-imaged with auxiliary optics (not shown) onto the detector. The pupil plane is the plane in which the radial position of radiation defines the angle of incidence and the angular position defines the azimuth angle of the radiation. The detector is preferably a two-dimensional detector so that a two-dimensional angular scatter spectrum of a substrate target 30 can be measured. The detector 18 may be, for example, an array of CCD or CMOS sensors, and may use an integration time of, for example, 40 milliseconds per frame.

A reference beam is often used for example to measure the intensity of the incident radiation. To do this, when the radiation beam is incident on the beam splitter 16 a part of the radiation beam is transmitted through the beam splitter as a reference beam towards a reference mirror 14. The reference beam is then projected onto a different part of the same detector 18.

A set of interference filters 13 is available to select a wavelength of interest in the range of, for example, 405 - 790 nm or even lower, such as 200 - 300 nm. The interference filter may be tunable rather than comprising a set of different filters. A grating could be used instead of interference filters.

The detector 18 may measure the intensity of scattered light at a single wavelength (or a relatively narrow wavelength range), the intensity may be measured separately at multiple wavelengths or integrated over a wavelength range. Furthermore, the detector may separately measure the intensity of transverse magnetic- and transverse electric-polarized light and/or the phase difference between the transverse magnetic- and transverse electric-polarized light.

Using a broadband light source (i.e. one with a wide range of light frequencies or wavelengths - and therefore of colors) is possible, which gives a large attenuation, allowing the mixing of multiple wavelengths. Preferably each of the plurality of wavelengths in the broadband has a bandwidth of Δλ and a spacing of at least 2 Δλ (i.e. twice the bandwidth). Several "sources" of radiation can be different portions of an extended radiation source which have been split using fiber bundles. In this way, angle resolved scatter spectra can be measured at multiple wavelengths in parallel. A 3-D spectrum (wavelength and two different angles) can be measured, which contains more information than a 2-D spectrum. This allows more information to be measured which increases metrology process robustness. This is described in more detail in EP1,628,164A.

The target 30 on substrate W may be a grating, which is printed such that after development, the bars are formed of solid resist lines. The bars may alternatively be etched into the substrate. This pattern is sensitive to chromatic aberrations in the lithographic projection apparatus, particularly the projection system PL, and illumination symmetry and the presence of such aberrations will manifest themselves in a variation in the printed grating. Accordingly, the scatterometry data of the printed gratings is used to reconstruct the gratings. The parameters of the grating, such as line widths and shapes, may be input to the reconstruction process, performed by processing unit PU, from knowledge of the printing step and/or other scatterometry processes.

As mentioned above, before exposure of a substrate can take place, the alignment and other characteristics of the substrate need to be determined and it is therefore necessary to perform a measurement process, including an alignment operation, before the exposure process can be performed. The measurement process is vital to obtain information about the alignment of the substrate and to ensure correct overlay between successive layers of patters to be formed on the substrate. Typically a semiconductor device may have tens or even hundreds of patterned layers, which need to be overlaid with high accuracy otherwise the devices cannot function correctly.

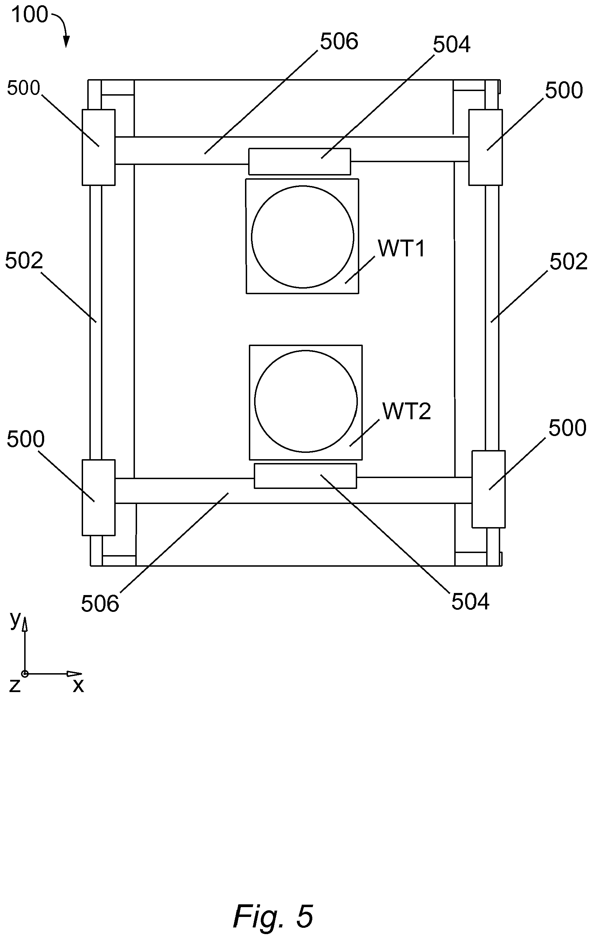

Figure 5 shows a first example of a stage unit 100In this and other figures, references to the x and y directions are generally taken to mean the respective orthogonal axes in the plane of the substrate or substrate table, namely the horizontal plane. References to the z-direction are taken to mean a direction in an axis orthogonal to the x and y axes, namely a vertical direction. The z-direction can also be referred to as "height". It is to be appreciated however that the labeling of one axis as "x", one as "y" and one as "z" is in essence arbitrary. The figures are provided with references to guide the reader as to the designation of a particular axis as "x", "y" or "z" in each case.

The stage unit 100 comprises a first substrate table WT1 and a second substrate table WT2. Both substrate tables are suitable to receive and support a substrate, typically a wafer. In use, one of the substrate tables will be positioned beneath the projection system PL while it performs an exposure, while at the same time the other of the substrate tables can be positioned with respect to various sensor components to perform measurement of the substrate carried by the substrate table.

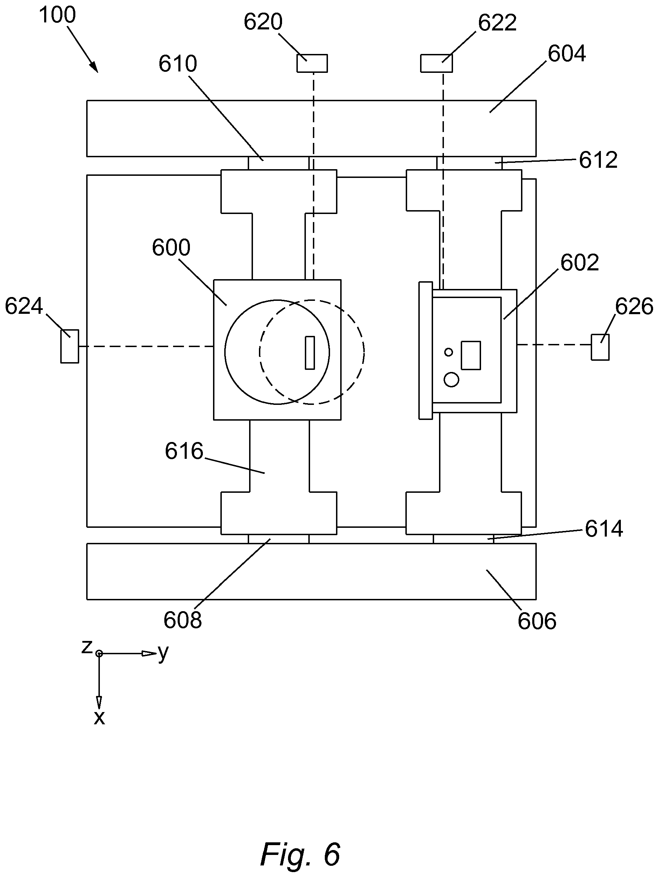

In the example embodiment of Fig. 5 a component for moving and controlling the substrate tables WT1 and WT2 comprises a motor with Y-sliders 500 arranged to slide along rails 502 in the y-axis and X-sliders 504 arranged to slide along rails 506 in the X-axis so that the position of the wafer tables in the X and Y axis can be changed. Because of the shape of the rails 506, 502, this type of arrangement is referred to herein as an H drive motor or mechanism. An alternative to this H drive mechanism is to use a planar motor wherein the motor directly drives the wafer tables. Figure 6 shows a second example of a stage unit 100 which comprises a separate wafer stage 600 and measurement stage 602. The stage unit 100 is provided with Y-axis stators 604, 606 and the wafer stage 600 is moveable along the Y-axis by Y-axis movers 608, 610 while the measurement stage 602 is moveable along the Y-axis by Y-axis movers 612, 614. The Y-axis stators 604, 606 in combination with the Y-axis movers 608, 610 form a Y-axis linear motor for moving the wafer stage 600, while the Y-axis stators 604, 606 in combination with the Y-movers 612, 614 form a Y-axis linear motor for driving the measurement stage 602 in the Y direction. In one embodiment the stators 604, 606 can be composed of a magnetic pole unit comprising a plurality of permanent magnets comprising alternately placed north and south poles along the Y-axis direction, while the movers 608, 610, 612, 614 can comprise in each case an armature unit incorporating armature coils placed at predetermined distances along the Y-axis direction. This is referred to as a moving coil type Y-axis linear motor.

The wafer stage 600 and the measurement stage 602 are positioned on X-axis stators 616, 618 respectively. The X-axis stators 616, 618 may for example comprise an armature unit which incorporates armature coils placed at a predetermined distance along the X-axis direction. Openings in the wafer stage 600 and measurement stage 602 can comprise a magnetic pole unit comprising a plurality of permanent magnets made up of alternating pairs of north and south pole magnets. The magnetic pole unit and stators constitute a moving magnet type X-axis linear motor provided for driving the wafer stage 600 along an X direction as illustrated in the figure, and a second similar moving magnet type linear motor for driving the measurement stage 602 along the X direction as shown in the figure.

Therefore, the Y and X-axis linear motors form components for moving and controlling the wafer stage 600 and measurement stage 602. Mechanisms for determining the positions of the wafer stages will be discussed later. However, in figure 6 interferometers 620, 622, 624 and a 626 are provided for measurement of the X and Y positions of each of the stages. The beams from the interferometers (shown as dotted lines in the figure) reflect from polished mirrored surfaces of the respective stages 600, 602 (these surfaces extend in the Z direction as shown in the figure, namely out of the page) and the time taken for a beam to be reflected is used as a measurement of the position of the stage along the X or Y axis.

The accuracy of control of a wafer stage using interferometers is limited by air fluctuations in the relatively long optical paths of the interferometer beams. An alternative to interferometers is to use an encoder for determining the position of the wafer stages.

It is common for a lithographic apparatus to include both an encoder system together with an interferometer system. The encoder system in this case will generally be the main system used for measurement of the positions of the stages in the X and Y-axis, with the interferometer system being provided for use during testing or calibration of the encoder system or as a back-up positional detection system if there are cases where the encoder system cannot be used (for example in the system of figure 6 a Y-axis interferometer needs to be used to measure the Y position of the wafer stage 600 near the unloading position or the loading position for wafer replacement and also at the point between a loading operation and an alignment operation and/or between an exposure operation and an unloading operation).

An encoder system may, for example, comprise a sensor element and a diffraction grating. The sensor element is arranged to detect radiation reflected from or transmitted through the diffraction grating and to detect the periodic pattern which can be fed from the sensor to a computer for calculating the position represented by the encoded values.

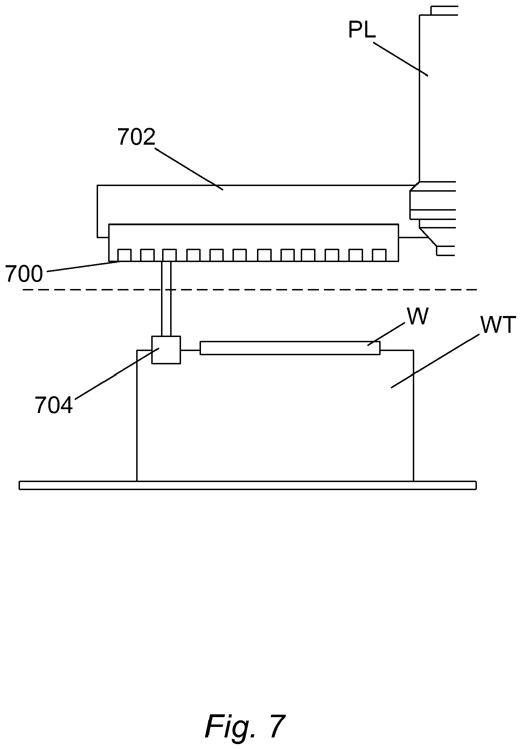

Figure 7 shows an embodiment where a diffraction grating 700 is provided on a metrology frame 702, with a sensor 704 being provided on a wafer stage WT1 holding a wafer W. In this embodiment the metrology frame 702 is fixedly attached to the project unit PL.

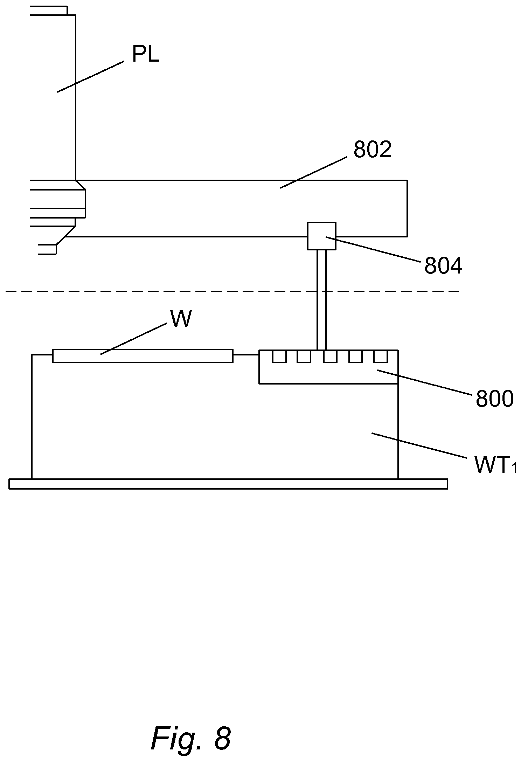

Figure 8 shows an alternative embodiment wherein the diffraction grating is provided at the wafer stage WT1 holding a wafer W and a sensor element 804 is provided on a metrology frame 802 which in this example again is fixedly attached to the projection unit PL.

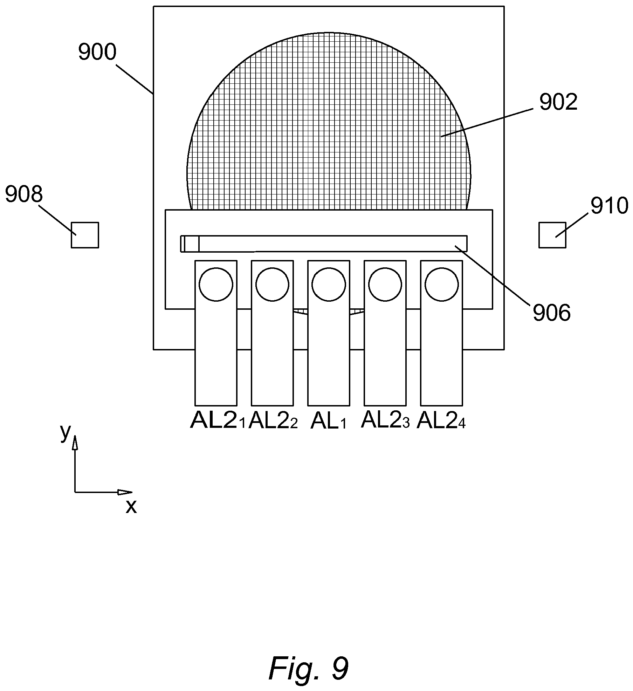

One of the key tasks in the measurement stage is the alignment measurement of a wafer. One example alignment system is shown in the figure 9. This alignment system incorporates multiple alignment heads AL1 and AL21, AL22, AL23 and AL24. Different numbers and arrangements of alignment heads are possible. The alignment heads are shown generically in figure 9 as being positioned over a wafer stage 900 which can be for example the wafer stage 600, WT1 or WT2 as shown in previous figures, or other wafer stages for example.

Wafer stage 900 is shown as holding a wafer 902. In this example five alignment heads are provided. A central alignment head AL1 forms part of a primary alignment system and so is referred to as a "primary alignment head", while the outer alignment heads AL21, AL22, AL23 and AL24 form part of a secondary alignment system, and so are referred to as "secondary alignment heads". Also shown in figure 9 is a leveling sensor 906 with radiation source 908 and radiation detector 910, which will be described in more detail later.

Each alignment head AL1, AL21, AL22, AL23, AL24 comprises a sensor element which is designed to detect an alignment mark, which can be provided on the wafer or on the wafer stage; or on the measurement stage if applicable. The alignment mark can be, for example, a specially printed feature at a point on the wafer, for example, an alignment mark can be printed on the scribe lanes which run between successive columns and/or rows of die elements on the wafer. It is also possible to use a feature of the pattern formed on the wafer as an alignment marker or to use specific alignment marks which are printed within the die elements on the wafer.

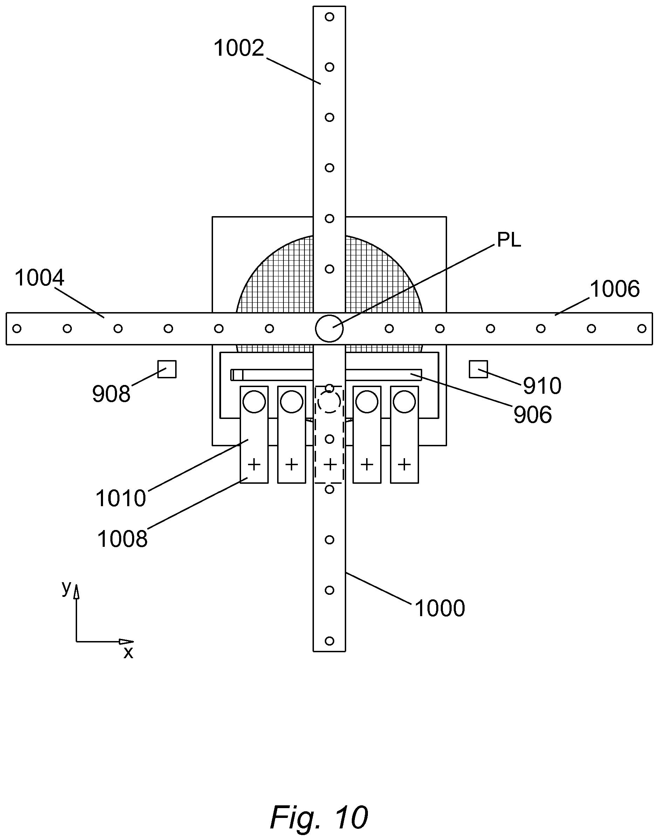

The alignment heads AL1, AL21, AL22, AL23, AL24 may be attached to a metrology frame which includes encoder sensors, as illustrated in figure 10. In this figure the primary alignment head AL1 is fixed to the underside surface of a first Y encoder 1000. The apparatus further comprises a second Y encoder 1002 and first and second X encoders 1004, 1006. The first and second Y encoders may be provided as a single component and the first and second X encoders may also be provided as a single component.

In the illustration of figure 10 the encoders are all fixedly attached to the project unit PL. This corresponds to the embodiment shown in figure 8 - each encoder sensor corresponds to the sensors 804 which are positioned to detect the position with a diffraction grating provided on the wafer table. As an alternative the sensors may be provided on the wafer table and look up towards diffraction gratings provided on the metrology frame.

The secondary alignment heads AL21, AL22, AL23, AL24 are moveable in the X direction. In one embodiment each of the secondary alignment heads AL21, AL22, AL23, AL24 is fixed to a turning end of an arm that can turn around a rotation centre in a predetermined angle range in clockwise and anti-clockwise directions (rotation centre 1008, arm 1010). The X axis position of the secondary alignment heads AL21, AL22, AL23, AL24 can also be adjusted by a drive mechanism that drives the secondary alignment heads back and forth in the X direction. It is also possible for the secondary alignment heads to be driven in the Y direction.

Once the arms of the secondary alignment systems are moved to a given location a fixing mechanism is selectively operable to hold the arms in position. The fixing mechanism may comprise a vacuum pad that is composed of a differential type air bearing which can be activated to fix the arm 1010 to the main frame by suction after the rotation adjustment of the arm is complete. Other fixing mechanisms may be used, for example, forming a portion of the main frame arm as a magnetic body and using an electromagnet.

The image sensors used in the alignment heads may, for example, comprise a field image alignment system or other appropriate image sensor. The field image alignment system irradiates a broadband detection beam that does not expose resist on a wafer to a subject alignment mark, and picks up an image of the subject mark formed on a light receiving plane by the reflected light from the subject mark and an image of an index, which can be an index pattern on an index plate arranged within each alignment head. In general any alignment sensor can be used which irradiates a coherent detection light to a subject mark and detects a scattered light or a diffracted light generated from the subject mark, or makes two diffracted lights generated from the subject mark interfere and to detect an interference light.

It is to be noted that the alignment system in figures 9 and 10 comprises five alignment heads, however other numbers of alignment heads could be used, including both odd and even numbers.

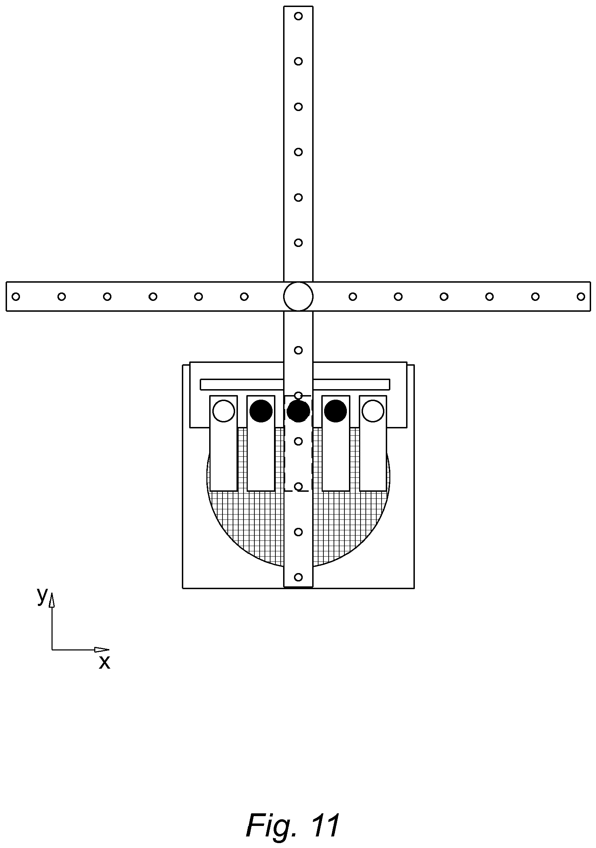

An alignment operation using the alignment head and encoder embodiments shown in figures 9 and 10 will now be described. It is to be appreciated that similar alignment operations can be carried out using the other embodiments mentioned. In an alignment process the wafer table is positioned at an initial position, as shown in figure 11. In this example three of the alignment heads, namely the primary alignment head AL1 and its two nearest neighbors AL22 and AL23 detect alignment marks on the wafer. The outlying alignment heads which do not detect alignment marks are in a preferred embodiment switched off. However they may be switched on if required for other purposes. A filled-in shape represents an alignment head that is active.

The wafer stage is then moved from the initial detection position to a second detection position at which a number of the alignment heads perform a measurement of respective alignment marks on the wafer. A number of measurement positions can be defined along the Y-axis with the multiple alignment heads measuring multiple alignment marks at each position.

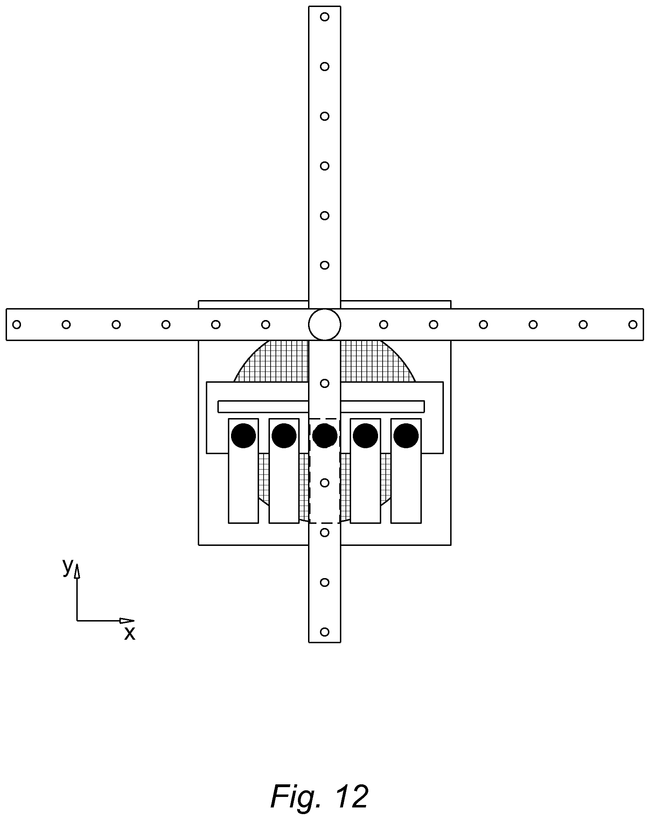

Figure 12 shows a further, so-called "downstream", alignment detection position in which all five alignment heads are active (i.e. all alignment heads are indicated with a filled-in shape in figure 12). It is to be appreciated that any suitable number of alignment detection positions can be chosen. The more positions that are chosen the more accurate the system can be, although the more time consuming the alignment process will be. For example, it is possible to define sixteen alignment marks in successive rows along the X-axis on the wafer comprising three, five, five and three marks respectively which can then be detected by four different alignment positions which make use of three, five, five and three alignment heads respectively. The number of rows of alignment marks can be less or more than five and can even be as high as many hundreds.

The measurements carried out by multiple alignment heads are carried out simultaneously where possible. However, due to the differing height along the surface of a wafer, a leveling process is typically carried out. This can be performed by moving the wafer stage up and down in the Z-axis as controlled by a further encoder system. Alternatives to this will be discussed below. A z-leveling sensor 906, 908, 910 is provided which uses a focus detection technique to determine when the wafer is in line with a predetermined focal plane of the leveling sensor. In an embodiment the position of the wafer stage in the X-axis is set so that the primary alignment system AL1 is placed on the centre line of wafer table WTB and primary alignment system AL1 detects the alignment mark which is on the meridian of the wafer.

The data from the alignment sensors AL1, AL21, AL22, AL23, AL24 can then be used by a computer to compute an array of all the alignment marks on the wafer in a co-ordinate system that is set by the measurement axis of the x and y encoders and the height measurements by performing statistical computations in a known manner using the detection results of the alignment marks and the corresponding measurement values of the encoders, together with the baseline calibration of the primary alignment system and secondary alignment system, which will be discussed in more detail below.

In the above embodiment the wafer stage can be moved in the Y direction and the measurements of the marks can be made without moving the wafer in the X direction. However it is to be appreciated that an alignment system as illustrated may be moveable in the X direction to collect additional measurements for computing the array of alignment marks, for example in the case where a larger wafer is to be measured and/or a smaller number of alignment heads are to be used and/or the alignment heads are to be spaced together within a shorter X-axis range.

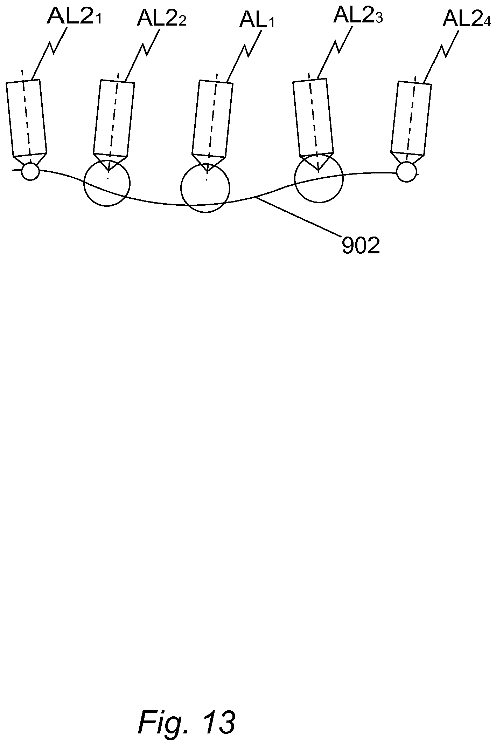

The surface of a wafer is not a flat plane and has some unevenness for example due to manufacturing tolerances as well as the unevenness introduced by the patterns which are formed on its surface. This means that it is highly probable that at least one alignment head performs detection of an alignment mark out of focus. Figure 13 shows an exaggerated example of this, where the middle three alignment heads AL22, AL1 and AL23 are out of focus with respect to the uneven wafer 902 surface.

Changing the relative position in the Z-axis of the wafer table allows each of the alignment heads to make a measurement in a focused state, although each movement in the Z-axis which is required results in an additional step and additional time that is required for the alignment. Further, the optical axis of the alignment system will not always coincide with the Z-axis direction due to a combination of the angular unevenness of the wafer surface, and the angular displacement of the arms of the secondary alignment system (in the case of the embodiment where the arms are rotatable). However, it is possible to measure the tilt with respect to the Z-axis of the optical axis of the alignment heads in advance so that the detection results of positions of the alignment marks can be corrected based on the measurement results.

Before the alignment process can be carried out however, a baseline calibration of the alignment system has to be carried out to ensure that it is correctly calibrated. A baseline calibration of the primary alignment system will now be described.

Firstly, the wafer is aligned against the fixed primary alignment head. The wafer stage has a fiducial mark for providing a reference point for the measurement of the position of the wafer stage. The fiducial mark is preferably also provided in a fixed positional relation to an imaging system arranged to detect radiation incident on the fiducial mark. During the primary baseline calibration the reticle is aligned against the fixed primary alignment head AL1.

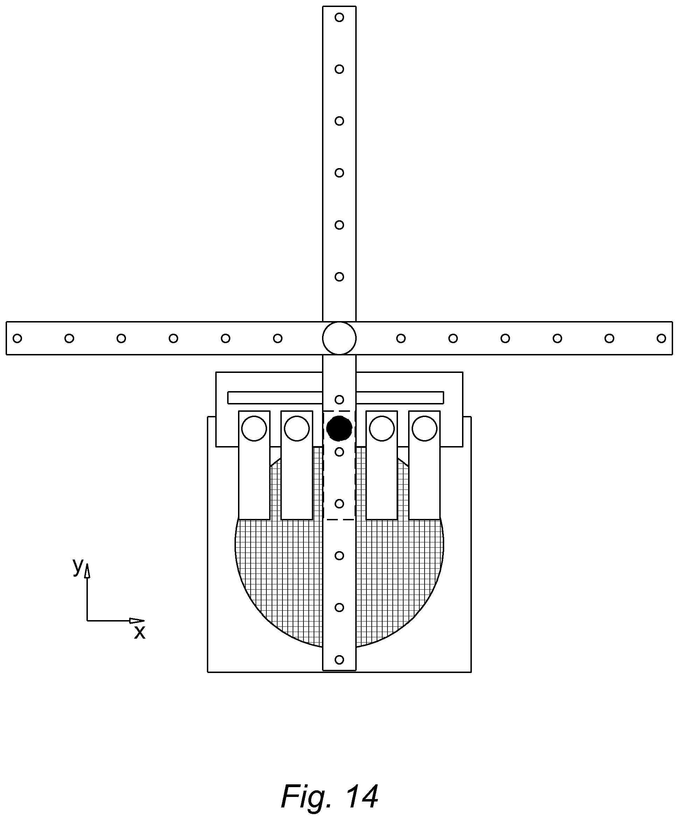

In a first stage of this primary baseline calibration, alignment head AL1 is positioned above the fiducial mark of the wafer stage and the X-Y position of the measurement is recorded, as shown in figure 14.

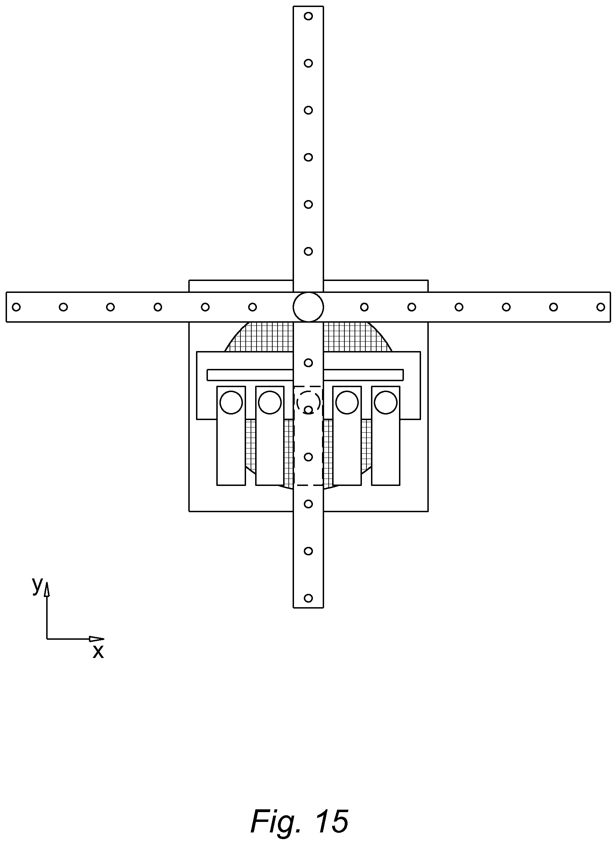

Then the substrate table is moved (along the Y direction as shown in the figure) to a second position, shown in figure 15, in which the fiducial mark is located directly below the projection optical system PL and a known point on the reticle (defined by a reticle alignment mark) is projected on to the fiducial mark and detected by the image sensor which co-operates with the fiducial mark. This position of the projected image is also recorded and the relative difference between the two recorded positions is used to calculate the alignment of the fixed alignment head AL1 with respect to the reticle. This is known as a primary baseline calibration.

Following the primary baseline calibration a secondary baseline calibration is performed to calculate the relative positions of the secondary alignment heads AL21, AL22, AL23, AL24 with respect to the fixed primary alignment head AL1. This secondary baseline calibration needs to be performed at the start of every lot of wafers to be processed.

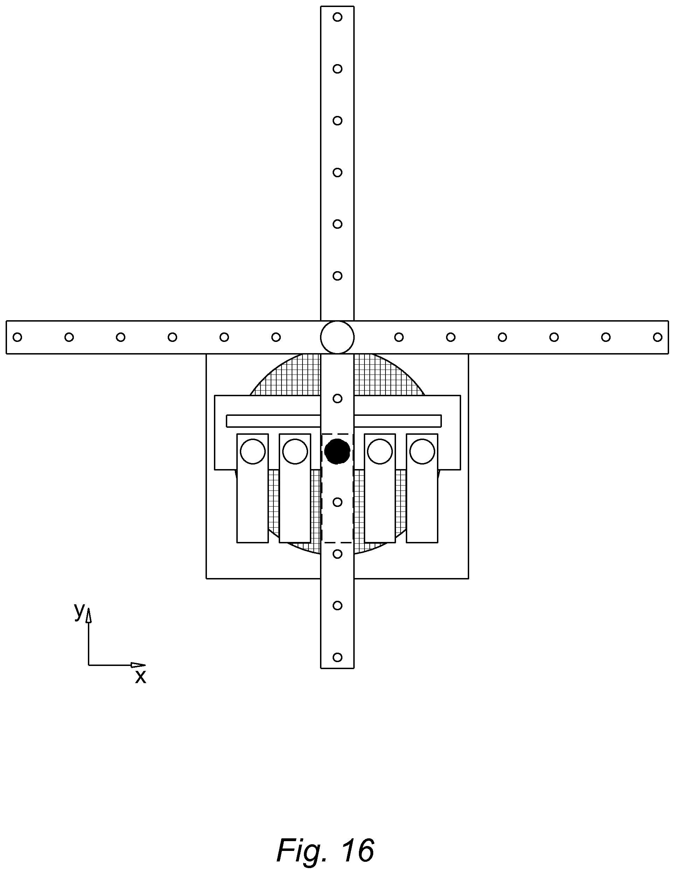

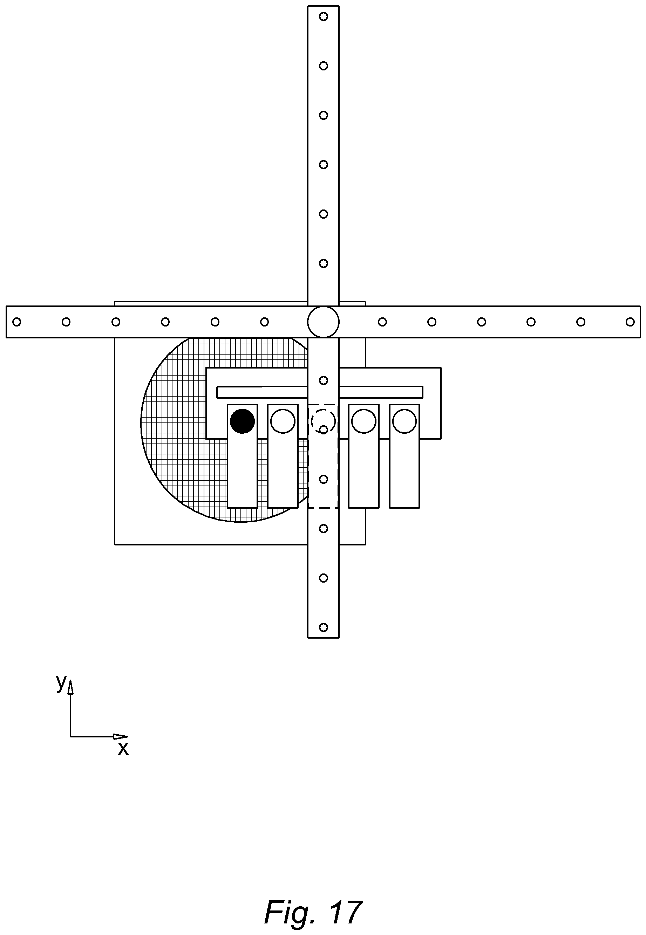

In an example, a wafer comprises five alignment marks M1, M2, M3, M4 and M5 in a specific row. One of the alignment marks, M3 in the illustrated example, is measured with the primary alignment head AL1 as shown in figure 16 (where again a filled-in shape is used to represent the alignment heads which are active - in this case, only the primary alignment head AL1). The wafer stage is then moved in the X direction by a known amount, and then the same wafer alignment mark M3 is measured with one of the secondary alignment heads. Figure 17 shows the measurement of the same mark with the secondary alignment head AL21.

The X-Y position measured is then stored in memory and compared with the X-Y position of mark M3 as detected with AL1 together with the known distance by which the wafer stage has moved, in order to calculate the baseline position of secondary alignment headAL21 with respect to primary alignment head AL1.

The wafer stage is then moved in the X direction so that the same wafer alignment mark M3 is measured with the adjacent secondary alignment head, AL22, whose X-Y position is calibrated with respect to the primary alignment head AL1 in the same manner. This is then repeated for the remaining secondary alignment heads AL23 and AL24.

The difference in detection offset among the alignment systems can then be corrected in subsequent processing of data.

It is also possible to perform a secondary baseline calibration based on reference points other than an alignment mark on the wafer, for example an alignment mark on the wafer stage or measurement stage.

It is also possible to provide a plurality of datum marks in the same positional relation as that of the alignment heads AL21, AL22, AL23, AL24 so that each of the secondary alignment heads can measure their respective dedicated datum point in parallel. The datum points have a known positional relation with respect to the fiducial mark, which enables calibration of the position information of each of the secondary alignment heads with respect to the primary alignment head to be calculated based on the acquired measurements.

In a variation of the first method, a plurality of alignment marks can be measured in parallel by the secondary alignment heads, that is, taking two or more measurements as part of the same measurement step. The wafer is moved (for example in an X direction) and the primary alignment head is used to measure an alignment mark previously measured by one of the secondary alignment heads. The measured X-Y positions of the secondary alignment head and the primary alignment head for that mark, together with the known offset introduced by the wafer movement are used to calculate the baseline of the secondary alignment head. This process is then repeated for each of the alignment marks so that each of the secondary alignment heads is calibrated with respect to the primary alignment head AL1.

These calibration procedures present some problems however. In the first method where a given mark is measured with successive alignment heads of the second alignment system, if the mark being used is defective or results in low SNR detections (signal to noise ratio), there may be significant errors in all the relative positions of the alignment heads. The second method, in which different marks are used to cross calibrate each secondary alignment head with the primary alignment head, has an advantage over the first method in that if one of the marks is defective or produces a low SNR detection only one of the heads would be affected. However, variations between the four individual marks measured by the four individual secondary alignment heads may result in mark dependent offsets and in this case the accuracy may even be worse than in the first method.

Any errors in the relative alignment head offsets may affect the overlay in the entire wafer lot and in the worst case this can reduce or completely destroy yield.

It is therefore required to provide a more robust and accurate method to calibrate the relative positions of alignment heads in a multiple alignment head system.

Accordingly there can be provided, in an alignment system of the type comprising multiple alignment heads which are used to detect alignment marks of an object such as a wafer or substrate table, a method of calibration of one or more secondary alignment heads with one or more primary alignment heads.

The primary alignment head or heads can be attached to a fixed frame known as a metrology frame.

Other components may also be attached to the metrology frame, for example a projection lens unit or part thereof.

The alignment head offsets of the secondary alignment heads can be calculated not just from one measurement, but from multiple measurements. This improves the robustness and accuracy of the calibration. The multiple measurements are preferably made in parallel by the multiple alignment heads, that is, taking two or more measurements as part of the same measurement step.

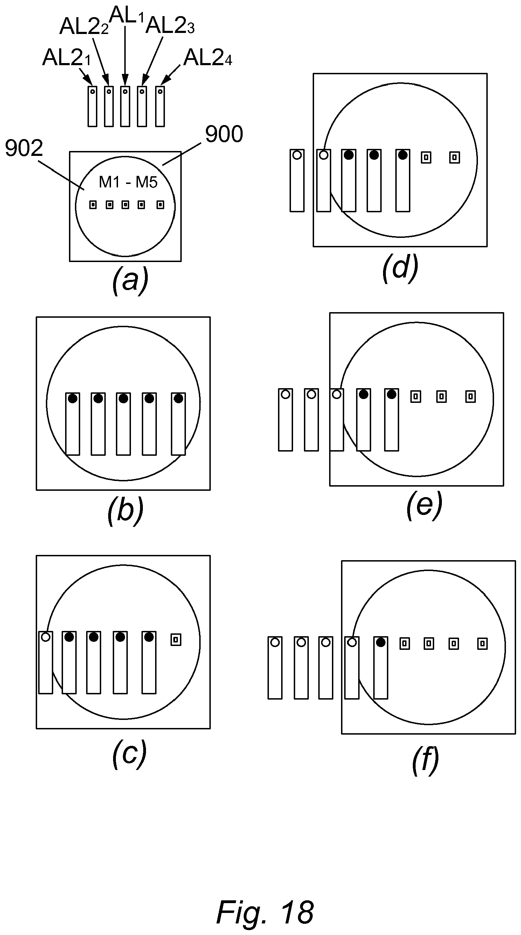

Figure 18 shows an embodiment of a secondary alignment head calibration procedure for illustrative purposes. As shown in Figure 18a, five alignment heads AL1 and AL21, AL22, AL23, AL24 are arranged for the detection of five alignment marks M1-M5 (from M1 on the left-side of the figure to M5 on the right-side of the figure) on the wafer 902 which is held on stage 900. In figure 18 the alignment head sensors are indicated as being filled in when they are active and clear when they are inactive. It is to be appreciated that the sensors could be left active at all times, although the selective activation of the alignment head sensors is preferred as it uses less energy and cuts down on potential cross talk errors.

In figure 18 primary alignment head AL1 and secondary alignment heads AL21, AL22, AL23, AL24 are provided. In figure 18b all the marks M1-M5 are simultaneously measured by the five alignment heads. Following this, the wafer stage 900 is moved a predetermined distance in the X direction to the position shown in figure 18c, following which alignment head AL21 moves to a position outside of the wafer boundary (or at least outside of that area of the wafer that comprises the marker array) and becomes inactive. Mark M5 is then not measured by any of the alignment heads. The remaining four alignment heads measure marks M1-M4. The process of moving the wafer in the X direction and then performing subsequent measurements can then be repeated until only one alignment sensor and one mark are matched up, as shown in the sequence of figure 18b to 18f.

It is to be appreciated that the process of figures 18b to 18f shows the movement of the stage 900 in a first X-direction with respect to the alignment heads. However, the stage 900 may equally be moved in the opposite X-direction to achieve the same effects.

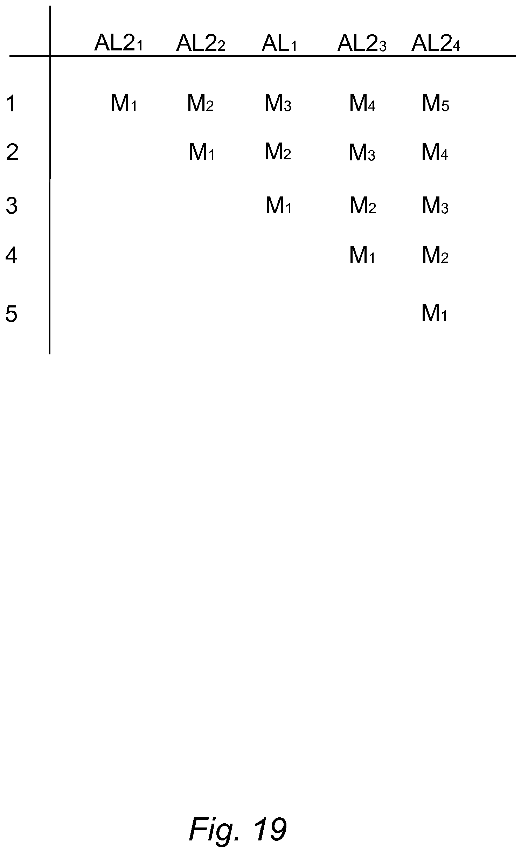

At this point mark M1 (the left hand side mark) has been measured by all five alignment heads, M2 has been measured by four of the alignment heads (i.e. by AL22, AL1, AL23 and AL24 respectively) and so on. Figure 19 displays an overview of the marks that have been measured by the respective alignment heads at this point. Steps 1-5 in the table correspond to the positions of figures 18b-f respectively. Alignment head AL21 has made only one measurement, while AL22 has made two measurements, AL23 has made three measurements and AL24 has made four measurements. The alignment head of the primary alignment system AL1 has made three measurements.

Gathering of offset information about each of the alignment heads can therefore be obtained from a plurality of measurements.

The measurement of an offset of a secondary alignment head AL21, AL22, AL23, AL24 can be determined when the measurement of a particular alignment mark M1-M5 can be correlated to a measurement of an alignment mark made by the primary alignment head AL1. The difference in X-Y positions represents the offset of the subject secondary alignment head with respect to the primary alignment head.

As a minimum, at least one secondary alignment head measures at least one mark in common with the primary alignment head. This enables a direct measurement of the offset of that secondary alignment head to be made. The remaining secondary alignment heads, which do not measure at least one mark in common with the primary alignment head, can be calibrated with reference to the secondary alignment head or heads that do measures at least one mark in common with the primary alignment head.

In a preferred embodiment, the primary alignment head AL1 measures at least one alignment mark in common with each of the secondary alignment heads AL21, AL22, AL23, AL24. This means that the offset of each of the secondary alignment heads AL21, AL22, AL23, AL24 can be determined by direct measurement. So in the embodiment of figure 19, multiple offsets can be calculated for all of the alignment heads through direct measurement, except for AL21.

In a further embodiment, the primary alignment head AL1 measures at least two alignment marks in common with each of the secondary alignment heads AL21, AL22, AL23, AL24.

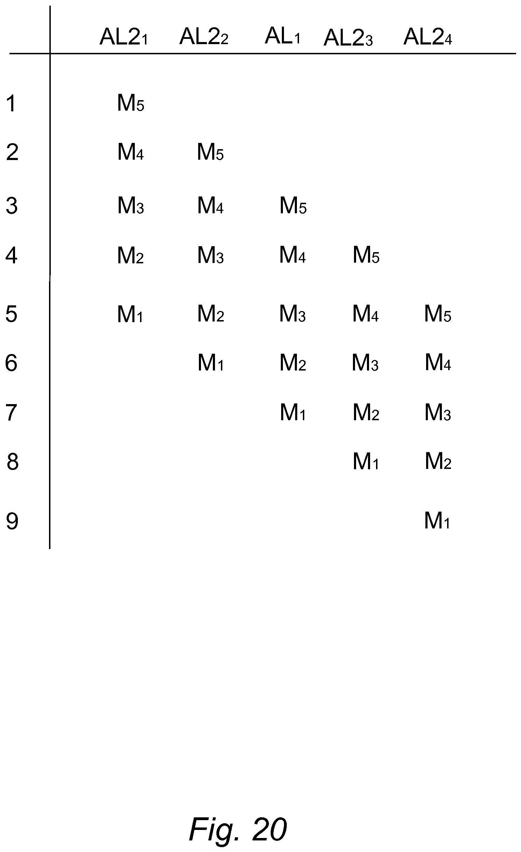

Figure 20 shows a table with all the possible alignment positions for the example embodiment of five alignment heads measuring five alignment marks. In this case there are nine possible positions, or "steps" for offset measurement.

As mentioned above a minimum requirement for offset measurement at least one secondary alignment head measures at least one mark in common with the primary alignment head. It is possible to meet the requirement for this embodiment, for the example of five alignment marks and five alignment heads, with a minimum of two steps. In the diagram of Figure 20, the two steps could be any two steps so long as the primary alignment head makes a measurement in at least one of those steps, that is, steps 3, 4, 5, 6, or 7 in combination with any other step.

In a specific embodiment, both of the two steps may include measurement of different markers by the primary alignment head, so that the number of secondary alignment heads that do not measure any mark in common with the primary alignment head is minimized. For example, in the diagram of Figure 20, when the two steps comprise either steps 4 and 5 or steps 5 and 6, only the two outer secondary alignment heads, AL21 and AL24, do not measure a mark in common with the primary alignment head AL1.

In another embodiment, the primary alignment head AL1 measures at least one mark in common with each of the secondary alignment heads AL21, AL22, AL23, AL24. It is possible to meet this requirement for this embodiment, for the example of five alignment marks and five alignment heads, with a minimum of three steps. The three steps must include the position where all of the alignment heads are active (as illustrated in figure 18b), which can be at the start, the centre or the end of a series of three consecutive steps, that is, steps {3,4,5}, {4,5,6} or {5,6,7} as illustrated in Figure 20 (note that for each case, the steps can be carried out in any order).

In this case (that is, again for the example embodiment of five alignment heads), both the outer secondary alignment heads (AL21 and AL24) will measure one alignment mark in common with the fixed alignment head AL1, and so a direct measurement of their offset can be made. However the remaining secondary alignment heads each measure two alignment marks in common with the fixed alignment head and thus provide two offset measurements which can be used to increase the robustness of the calibration.

In another embodiment, each of the secondary alignment heads measures at least two alignment marks in common with the alignment marks measured with the fixed alignment head AL1. The minimum number of steps required to carry this out in the example of figures 18-20 is four. In this case, the steps must be consecutive and the central step must be one of the middle steps involved. In other words, the four steps must be either numbers {3,4,5,6} or {4,5,6,7} in the diagram of figure 20

It is to be understood the use of the term "consecutive" when referring to positions of the wafer stage refers to the ordering of the steps in the figure, rather than necessarily the ordering of the steps in time. It is possible to move the wafer to each of the positions in a different order in time to that illustrated in the figure. As such, "consecutive" steps are understood to represent adjacent wafer stage positions or steps which are logically consecutive in a sequence as illustrated.

The same effects can also be achieved by using additional steps. Each additional step above the minimum three or four steps will result in extra data being collected and extra robustness to the calibration method.

In an alternative embodiment all steps that yield a measurement of at least one alignment mark are used (that is, all nine steps in the illustrated example), so that all of the alignment marks are measured by each of the alignment heads and the maximum amount of data is collected.

The above mentioned description refers to the specific example of five alignment heads used to measure a set of five alignment marks. However, it will be appreciated that the invention is not limited to this case and is valid for any number, i, of alignment heads in combination with any number, j, of alignment marks. In a preferred embodiment i=j, however this does not always have to be the case. For example, it is possible to have say seven or three alignment heads. Or, five alignment heads like the ones illustrated could be used but with a greater number of alignment marks, such as nine - in which case the spacing between the marks would be half that of the spacing between the alignment heads.

In general, at least two different steps must be carried out such that at least one secondary alignment head measures at least one mark in common with the primary alignment head.

In an example embodiment, the primary alignment head measures at least one alignment mark in common with each of the secondary alignment heads. In this case, where there are i alignment heads the number of steps required as a minimum to perform calibration will be i-2. These i-2 steps must comprise consecutive steps with the central position at the start, centre or end of the sequence.

In another embodiment, the primary alignment head measures at least two alignment marks in common with each of the secondary alignment heads. In this case, where there are i alignment heads the number of steps required as a minimum to perform calibration with a plurality of offset measurements for each of the alignment heads will be i-1. These i-1 steps must comprise consecutive steps with the central position being the middle position, or one of the two middle positions, in the sequence.

It is also possible that the fixed alignment head is not positioned in the centre of the array. For example, the secondary alignment heads could be arranged in a line with each of them having a subsequently increasing lateral distance from the fixed primary alignment head, or alternative arrangements such as circular arrays of secondary alignment heads may be employed. In these alternative arrangements, the principles of the invention may still apply, however, in the case of a fixed alignment head at one end of an array of alignment heads, the minimum number of steps required to meet the requirements for calculation of offset in the first instance and then for calculation of multiple offsets per alignment head will require additional steps as compared with the centrally placed alignment head. It is to be appreciated that other physical mechanisms and movements in the axes may be employed, for example if the multiple alignment heads are arranged in a circular formation, the fixed alignment head could be in the centre of the circle and the various steps could be achieved by rotation of the wafer stage. In an alternative embodiment a central fixed primary alignment head can be at a centre point in the wafer and the wafer can be rotated for detection of a number of different alignment marks which are radially spaced around the central fixed primary alignment head. The offsets in the radial and angular directions can then be calculated.

It is to be appreciated that the various measurements of the alignment marks that are made can include positions in the X, Y and Z axes as well as tilt information.

Given these techniques and the extra data gathering capability of the new methods there are various algorithms that may be used for the calculation of the calibration and then subsequent amendment of a lithographic process based upon the calibration calculations.

In an example, one of the alignment marks is chosen to be used for calibration of all of the alignment heads, however the offsets derived from that alignment mark can be compared with the offsets derived from the other marks. If a mismatch is found (that is, if the measured offsets are found to differ by more than a predetermined error threshold) it can be determined that the chosen mark used for calibration is defective, in which case the measurements made based upon that alignment mark can be ignored and the measurements derived from an alternative alignment mark can be used instead. If necessary, in one of the embodiments where a reduced number of steps is used (for example to use only the minimum steps required for any calibration to be performed or the minimum steps required to have a plurality of alignment marks to be measured in common with each of the alignment heads), an additional wafer stage step can be carried out and additional data can be collected in order to obtain the additional information required to calculate the offsets based upon the new chosen alignment mark.

Another example use of the calibration data is to make a composite offset calculation, namely an offset calculation that takes into account more than one offset reading, for example being the average offset or the median offset.

Methods like these could also be used to detect outliers which can then be ignored from subsequent calculations.

In embodiments where a larger number of steps are carried out than the required minimum, the time spent on calibration will be increased. However, as the calibration is typically carried out once for the processing of each wafer lot, the increased time is acceptable in light of the utility of the extra data that is gathered.

As a practical matter, the order of the steps that are carried out can be important. When a minimized number of steps is required, an advantageous embodiment would be to start with the position where a secondary alignment head positioned at one extreme end of the alignment head array measures a central alignment mark, and then to move the wafer in successive steps in the direction away from that extremity so that the first common mark to be measured by all of the alignment heads is the central mark of the wafer.

The wafer stage's range of motion may well in some cases limit how many steps are possible. For example in some immersion lithography systems the immersion liquid has to be on the wafer or the wafer table during the primary baseline calibration, which may limit the practical range of steps that can be carried out. However, it is to be appreciated that the invention has utility for any type of lithographic process and thus the limitations of one particular process should not be construed as limiting the scope of the invention to any particular process.

For each measurement made by an alignment head of an alignment marker, it is preferable that the mark is in focus, however as mentioned above the surface of the wafer is typically not flat and therefore in an embodiment the alignment markers are brought into focus during each measurement step. Therefore in embodiments where multiple alignment heads measure a plurality of alignment marks in parallel, the "parallel" measurements may not actually be simultaneous, but may in fact comprise a number of different measurements depending upon the arrangement of the alignment marks.

A measurement will be taken in a first position where at least one of the alignment marks is in focus, and then a measurement will taken in a second position where a different alignment mark is in focus, and this is repeated until a measurement has been taken with all the alignment marks in focus. Of course, there may be cases where all of the alignment marks are in the same focal plane and in that case the measurement can be simultaneous.

In an alternative embodiment a secondary baseline calibration can be carried out on a dummy wafer, rather than a process wafer.

Another criterion for determining if a mark is defective is to test whether the calibration method is outside some predetermined expected range.

These new data collection methods result in a number of significant advantages to the industry. The robust improvement of the accuracy of the calibration measurement of the moveable alignment heads relative to the central fixed alignment head can improve overlay. The sensitivity of the method to defective alignment marks helps increase yield because in a worst case scenario a defective alignment mark could result in an entire wafer lot being spoiled.

As mentioned above, calibration may be take a little longer as compared to the prior art, however the overall impact on throughput will be minimal as the calibration is run every lot and indeed the improvements in overlay and yield far outweigh any minimal disadvantages to the rate of throughput by the slightly increased time for calibration.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin film magnetic heads, etc.. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

In an embodiment of the invention there is provided a method of calibrating one or more secondary alignment heads with one or more primary alignment heads: the primary alignment head measures an alignment mark, at least one secondary alignment head measures the same alignment mark, and the offset of the secondary alignment head with respect to the primary alignment head is derived from the measurements made on that alignment mark, wherein the offset of a secondary alignment head that does not make a direct measurement of the alignment mark is calculated with reference to a secondary alignment head that does make a direct measurement of the alignment mark. Further, the primary alignment head may measure at least two alignment marks in common with each of the secondary alignment heads.

A method according to the invention may comprise, when measuring an alignment mark, determining one or more of the group comprising: X-position information, Y-position information, Z-position information, and tilt information. One alignment mark may be used for calibration of all the secondary alignment heads. Further, a method according to the invention may comprise comparing offsets measured with one candidate alignment mark with offsets measured with one or more other alignment marks, identifying the candidate alignment mark as defective if there is a mismatch between the offset measurement of the candidate alignment mark and the others, and, if said candidate alignment mark has been identified as defective, ignoring measurements made based upon that candidate alignment mark in subsequent calculations....

The descriptions above are intended to be illustrative, not limiting. Thus, it will be apparent to one skilled in the art that modifications may be made to the invention as described without departing from the scope of claims based on this disclosure.

To summarise, the present disclosure includes one or more of the following features:
1. A method of calibrating one or more secondary alignment heads with one or more primary alignment heads, wherein
   the primary alignment head measures an alignment mark;
   at least one secondary alignment head measures the same alignment mark; and the offset of the secondary alignment head with respect to the primary alignment head is derived from the measurements made on that alignment mark.
2. The method of feature 1, wherein the offset of a secondary alignment head that does not make a direct measurement of the alignment mark is calculated with reference to a secondary alignment head that does make a direct measurement of the alignment mark.
3. The method of feature 1, wherein the primary alignment head measures at least one alignment mark in common with each of the secondary alignment heads.
4. The method of feature 1, wherein the primary alignment head measures at least two alignment marks in common with each of the secondary alignment heads.
5. The method of feature 1, wherein all of the alignment marks are measured by both the primary alignment head and each of the secondary alignment heads.
6. The method of any preceding feature, wherein measuring an alignment mark comprises determining one or more of the group comprising: X-position information; Y-position information, Z-position information; and tilt information.
7. The method of any preceding feature, wherein one alignment mark is used for calibration of all the secondary alignment heads.
8. The method of feature 7, further comprising comparing offsets measured with one candidate alignment mark with offsets measured with one or more other alignment marks; identifying the candidate alignment mark as defective if there is a mismatch between the offset measurement of the candidate alignment mark and the others; and, if said candidate alignment mark has been identified as defective, ignoring measurements made based upon that candidate alignment mark in subsequent calculations.
9. The method of any preceding feature, wherein the plurality of measurements are made in parallel by the multiple alignment heads.
10. The method of feature 9, wherein the plurality of measurements are made simultaneously by the multiple alignment heads.
11. The method of feature 9, wherein the measurement step comprises, for each measurement head, bringing the alignment marker into focus.
12. The method of any preceding feature, wherein at least one alignment mark is provided on a wafer to be measured.
13. The method of any preceding feature, wherein at least one alignment mark is provided on a wafer stage or measurement stage.
14. The method of any preceding feature, wherein the primary alignment head or heads are attached to a metrology frame.
15. The method of feature 14, wherein the secondary alignment head or heads are moveable for alignment with an alignment mark.
16. A method of wafer alignment, performed as preparation for a lithographic process, wherein the wafer is measured by an alignment system that comprises a primary alignment system comprising a primary alignment head and a secondary alignment system comprising one or more secondary alignment heads; the method comprising
   performing a primary baseline calibration to align the primary alignment head with respect to a reference object;
   performing a secondary baseline calibration to align the secondary alignment heads with respect to the primary alignment head; and
   calibrating one or more secondary alignment heads with respect to the primary alignment head, wherein:
   the primary alignment head measures an alignment mark;
   at least one secondary alignment head measures the same alignment mark; and
   the offset of the secondary alignment head with respect to the primary alignment head is derived from the measurements made on that alignment mark.
17. The method of feature 16, wherein the offset of a secondary alignment head that does not make a direct measurement of the alignment mark is calculated with reference to a secondary alignment head that does make a direct measurement of the alignment mark.
18. The method of feature 16, wherein the primary alignment head measures at least one alignment mark in common with each of the secondary alignment heads.
19. The method of feature 16, wherein the primary alignment head measures at least two alignment marks in common with each of the secondary alignment heads.
20. The method of feature 16, wherein all of the alignment marks are measured by both the primary alignment head and each of the secondary alignment heads.
21. The method of any of features 16 to 20, wherein measuring an alignment mark comprises determining one or more of the group comprising: X-position information; Y-position information, Z-position information; and tilt information.
22. The method of any of features 16 to 21, wherein one alignment mark is used for calibration of all the secondary alignment heads.
23. The method of feature 22, further comprising comparing offsets measured with one candidate alignment mark with offsets measured with one or more other alignment marks; identifying the candidate alignment mark as defective if there is a mismatch between the offset measurement of the candidate alignment mark and the others; and, if said candidate alignment mark has been identified as defective, ignoring measurements made based upon that candidate alignment mark in subsequent calculations.
24. The method of any of features 16 to 23, wherein the plurality of measurements are made in parallel by the multiple alignment heads.
25. The method of feature 24, wherein the plurality of measurements are made simultaneously by the multiple alignment heads.
26. The method of feature 24, wherein the measurement step comprises, for each measurement head, bringing the alignment marker into focus.
27. The method of any of features 16 to 26, wherein at least one alignment mark is provided on a wafer to be measured.
28. The method of any of features 16 to 27, wherein at least one alignment mark is provided on a wafer stage or measurement stage.
29. The method of any features 16 to 28, wherein the primary alignment head or heads are attached to a metrology frame.
30. The method of feature 29, wherein the secondary alignment head or heads are moveable for alignment with an alignment mark.
31. The method of any of features 16 to 30, wherein the reference object comprises a patterning device.
32. Calibration apparatus comprising
   an alignment system comprising
   a primary alignment system comprising a primary alignment head and a sensor for detecting an alignment mark;
   a secondary alignment system comprising one or more secondary alignment heads, each comprising a sensor for detecting an alignment mark;
   a mechanism for moving the alignment system between a first position in which the primary alignment head measures an alignment mark; and a second position in which a secondary alignment head measures the same alignment mark;
   an encoder for measuring the position of the alignment system; and
   a processor for receiving measurements from the alignment system sensors and position information from the mechanism for moving the alignment system; and calculating from the measurements the offset of the secondary alignment head with respect to the primary alignment head.
33. The calibration apparatus of feature 32, wherein said processor is arranged to calculate the offset of a secondary alignment head that does not make a direct measurement of the alignment mark with reference to a secondary alignment head that does make a direct measurement of the alignment mark.
34. The calibration apparatus of feature 32, wherein the mechanism is suitable for moving the primary alignment head to measure at least one alignment mark in common with each of the secondary alignment heads.
35. The calibration apparatus of feature 32, wherein the mechanism is suitable for moving the primary alignment head to measure at least two alignment marks in common with each of the secondary alignment heads.
36. The calibration apparatus of feature 32, wherein the mechanism is suitable for moving the primary alignment head to measure all of the alignment marks by both the primary alignment head and each of the secondary alignment heads.
37. The calibration apparatus of any of features 32 to 36, wherein measuring an alignment mark comprises determining one or more of the group comprising: X-position information; Y-position information, Z-position information; and tilt information.
38. The calibration apparatus of any of features 32 to 37, wherein one alignment mark is used for calibration of all the secondary alignment heads.
39. The calibration apparatus of feature 38, wherein said processor is arranged for comparing offsets measured with one candidate alignment mark with offsets measured with one or more other alignment marks; identifying the candidate alignment mark as defective if there is a mismatch between the offset measurement of the candidate alignment mark and the others; and, if said candidate alignment mark has been identified as defective, ignoring measurements made based upon that candidate alignment mark in subsequent calculations.
40. The calibration apparatus of any of features 32 to 39, wherein, the plurality of measurements are made in parallel by the multiple alignment heads.
41. The calibration apparatus of feature 40, wherein the plurality of measurements are made simultaneously by the multiple alignment heads.
42. The calibration apparatus of feature 40, further comprising a mechanism for bringing the or each alignment marker into focus.
43. The calibration apparatus of any of features 32 to 42, wherein at least one alignment mark is provided on a wafer to be measured.
44. The calibration apparatus of any of features 32 to 43, wherein at least one alignment mark is provided on a wafer stage or measurement stage.
45. The calibration apparatus of any of features 32 to 44, wherein the primary alignment head or heads are attached to a metrology frame.
46. The calibration apparatus of feature 45, wherein the secondary alignment head or heads are moveable for alignment with an alignment mark.
47. A lithographic apparatus comprising
   calibration apparatus comprising
   an alignment system comprising
   a primary alignment system comprising a primary alignment head and a sensor for detecting an alignment mark;
   a secondary alignment system comprising one or more secondary alignment heads, each comprising a sensor for detecting an alignment mark;
   a mechanism for:
   moving the alignment system between measurement positions to perform a primary baseline calibration to align the primary alignment head with respect to a reference object, and a secondary baseline calibration to align the secondary alignment heads with respect to the primary alignment head;
   and for moving the alignment system between a first position in which the primary alignment head measures an alignment mark; and a second position in which a secondary alignment head measures the same alignment mark;
   an encoder for measuring the position of the alignment system; and
   a processor for receiving measurements from the alignment system sensors and position information from the mechanism for moving the alignment system; and calculating from the measurements the offset of the secondary alignment head with respect to the primary alignment head.
48. The lithographic apparatus of feature 47, wherein said processor is arranged to calculate the offset of a secondary alignment head that does not make a direct measurement of the alignment mark with reference to a secondary alignment head that does make a direct measurement of the alignment mark.
49. The lithographic apparatus of feature 47, wherein the mechanism is suitable for moving the primary alignment head to measure at least one alignment mark in common with each of the secondary alignment heads.
50. The lithographic apparatus of feature 47, wherein the mechanism is suitable for moving the primary alignment head to measure at least two alignment marks in common with each of the secondary alignment heads.
51. The lithographic apparatus of feature 47, wherein the mechanism is suitable for moving the primary alignment head to measure all of the alignment marks by both the primary alignment head and each of the secondary alignment heads.
52. The lithographic apparatus of any of features 47 to 51, wherein measuring an alignment mark comprises determining one or more of the group comprising: X-position information; Y-position information, Z-position information; and tilt information.
53. The lithographic apparatus of any of features 47 to 52, wherein one alignment mark is used for calibration of all the secondary alignment heads.
54. The lithographic apparatus of feature 53, wherein said processor is arranged for comparing offsets measured with one candidate alignment mark with offsets measured with one or more other alignment marks; identifying the candidate alignment mark as defective if there is a mismatch between the offset measurement of the candidate alignment mark and the others; and, if said candidate alignment mark has been identified as defective, ignoring measurements made based upon that candidate alignment mark in subsequent calculations.
55. The lithographic apparatus of any of features 47 to 54, wherein, the plurality of measurements are made in parallel by the multiple alignment heads.
56. The lithographic apparatus of feature 55, wherein the plurality of measurements are made simultaneously by the multiple alignment heads.
57. The lithographic apparatus of feature 55, further comprising a mechanism for bringing the or each alignment marker into focus.
58. The lithographic apparatus of any of features 47 to 57, wherein at least one alignment mark is provided on a wafer to be measured.
59. The lithographic apparatus of any of features 47 to 58, wherein at least one alignment mark is provided on a wafer stage or measurement stage.
60. The lithographic apparatus of any of features 47 to 59, wherein the primary alignment head or heads are attached to a metrology frame.
61. The lithographic apparatus of feature 60, wherein the secondary alignment head or heads are moveable for alignment with an alignment mark.
62. A computer program product, that, when executed on a computer, provides instructions for carrying out a method of calibrating one or more secondary alignment heads with one or more primary alignment heads, wherein the primary alignment head measures an alignment mark; at least one secondary alignment head measures the same alignment mark; and the offset of the secondary alignment head with respect to the primary alignment head is derived from the measurements made on that alignment mark.
63. A computer program product, that, when executed on a computer, provides instructions for carrying out a method of wafer alignment, performed as preparation for a lithographic process, wherein the wafer is measured by an alignment system that comprises a primary alignment system comprising a primary alignment head and a secondary alignment system comprising one or more secondary alignment heads; the method comprising performing a primary baseline calibration to align the primary alignment head with respect to a reference object; performing a secondary baseline calibration to align the secondary alignment heads with respect to the primary alignment head; and calibrating one or more secondary alignment heads with respect to the primary alignment head, wherein: the primary alignment head measures an alignment mark; at least one secondary alignment head measures the same alignment mark; and the offset of the secondary alignment head with respect to the primary alignment head is derived from the measurements made on that alignment mark.

## Claims

1. A method of calibrating one or more secondary alignment heads (AL21, AL22, AL23, AL24) with one or more primary alignment heads (AL1), wherein
the primary alignment head (AL1) measures an alignment mark (M1, M2, M3, M4, M5);
at least one secondary alignment head (AL21, AL22, AL23, AL24) measures the same alignment mark (M1, M2, M3, M4, M5); and
the offset of the secondary alignment head (AL21, AL22, AL23, AL24) with respect to the primary alignment head (AL1) is derived from the measurements made on that alignment mark (M1, M2, M3, M4, M5),
**characterized in that** the one or more primary alignment heads (AL1) measure at least two alignment marks (M1, M2, M3, M4, M5) in common with each of the at least one secondary alignment head (AL21, AL22, AL23, AL24).

2. The method of claim 1, wherein all of the alignment marks (M1, M2, M3, M4, M5) are measured by both the primary alignment head (AL1) and each of the secondary alignment heads (AL21, AL22, AL23, AL24).

3. The method of any preceding claim, wherein the plurality of measurements are made in parallel by the multiple alignment heads (AL1, AL21, AL22, AL23, AL24).

4. The method of claim 3, wherein the measurement step comprises, for each measurement head (AL1, AL21, AL22, AL23, AL24), bringing the alignment marker (M1, M2, M3, M4, M5) into focus.

5. A method of wafer alignment, performed as preparation for a lithographic process, wherein the wafer is measured by an alignment system that comprises a primary alignment system comprising a primary alignment head (AL1) and a secondary alignment system comprising one or more secondary alignment heads (AL21, AL22, AL23, AL24); the method comprising
performing a primary baseline calibration to align the primary alignment head (AL1) with respect to a reference object;
performing a secondary baseline calibration to align the secondary alignment heads (AL21, AL22, AL23, AL24) with respect to the primary alignment head (AL1); and
calibrating one or more secondary alignment heads (AL21, AL22, AL23, AL24) with respect to the primary alignment head (AL1), wherein:
the primary alignment head (AL1) measures an alignment mark (M1, M2, M3, M4, M5);
at least one secondary alignment head (AL21, AL22, AL23, AL24) measures the same alignment mark (M1, M2, M3, M4, M5); and
the offset of the secondary alignment head (AL21, AL22, AL23, AL24) with respect to the primary alignment head (AL1) is derived from the measurements made on that alignment mark (M1, M2, M3, M4, M5),
**characterized in that** the primary alignment head (AL1) measures at least two alignment marks (M1, M2, M3, M4, M5) in common with each of the at least one secondary alignment head (AL21, AL22, AL23, AL24).

6. The method of claim 5, wherein the plurality of measurements are made in parallel by the multiple alignment heads (AL1, AL21, AL22, AL23, AL24).

7. The method of claim 6, wherein the measurement step comprises, for each measurement head (AL1, AL21, AL22, AL23, AL24), bringing the alignment marker (M1, M2, M3, M4, M5) into focus.

8. Calibration apparatus comprising
an alignment system comprising
a primary alignment system comprising a primary alignment head (AL1) and a sensor for detecting an alignment mark (M1, M2, M3, M4, M5);
a secondary alignment system comprising one or more secondary alignment heads (AL21, AL22, AL23, AL24), each comprising a sensor for detecting an alignment mark (M1, M2, M3, M4, M5);
a mechanism for moving the alignment system between a first position in which the primary alignment head (AL1) measures an alignment mark (M1, M2, M3, M4, M5); and a second position in which a secondary alignment head (AL21, AL22, AL23, AL24) measures the same alignment mark (M1, M2, M3, M4, M5);
an encoder (1000, 1002, 1004, 1006) for measuring the position of the alignment system; and
a processor for receiving measurements from the alignment system sensors and position information from the mechanism for moving the alignment system; and calculating from the measurements the offset of the secondary alignment head (AL21, AL22, AL23, AL24) with respect to the primary alignment head (AL1),
**characterized in that** the mechanism is suitable for moving the primary alignment head (AL1) to measure at least two alignment marks (M1, M2, M3, M4, M5) in common with each of the secondary alignment heads (AL21, AL22, AL23, AL24).

9. A lithographic apparatus comprising
calibration apparatus comprising
an alignment system comprising
a primary alignment system comprising a primary alignment head (AL1) and a sensor for detecting an alignment mark (M1, M2, M3, M4, M5);
a secondary alignment system comprising one or more secondary alignment heads (AL21, AL22, AL23, AL24), each comprising a sensor for detecting an alignment mark (M1, M2, M3, M4, M5);
a mechanism for:
moving the alignment system between measurement positions to perform a primary baseline calibration to align the primary alignment head (AL1) with respect to a reference object, and a secondary baseline calibration to align the secondary alignment heads (AL21, AL22, AL23, AL24) with respect to the primary alignment head (AL1);
and for moving the alignment system between a first position in which the primary alignment head (AL1) measures an alignment mark (M1, M2, M3, M4, M5); and a second position in which a secondary alignment head (AL21, AL22, AL23, AL24) measures the same alignment mark (M1, M2, M3, M4, M5);
an encoder (1000, 1002, 1004, 1006) for measuring the position of the alignment system; and
a processor for receiving measurements from the alignment system sensors and position information from the mechanism for moving the alignment system; and calculating from the measurements the offset of the secondary alignment head (AL21, AL22, AL23, AL24) with respect to the primary alignment head (AL1),
**characterized in that** the mechanism is suitable for moving the primary alignment head (AL1) to measure at least two alignment marks (M1, M2, M3, M4, M5) in common with each of the secondary alignment heads (AL21, AL22, AL23, AL24).

10. The lithographic apparatus of claim 9, wherein, the plurality of measurements are made in parallel by the multiple alignment heads (AL1, AL21, AL22, AL23, AL24).

11. The lithographic apparatus of claim 10, further comprising a mechanism for bringing the or each alignment marker (M1, M2, M3, M4, M5) into focus.

## Patentansprüche

1. Ein Verfahren zum Kalibrieren eines oder mehrerer sekundärer Ausrichtungsköpfe (AL21, AL22, AL23, AL24) mit einem oder mehreren primären Ausrichtungsköpfen (AL1), wobei
der primäre Ausrichtungskopf (AL1) eine Ausrichtungsmarke (M1, M2, M3, M4, M5) misst;
mindestens ein sekundärer Ausrichtungskopf (AL21, AL22, AL23, AL24) dieselbe Ausrichtungsmarke (M1, M2, M3, M4, M5) misst; und
die Versetzung des sekundären Ausrichtungskopfs (AL21, AL22, AL23, AL24) in Bezug auf den primären Ausrichtungskopf (AL1) aus den an dieser Ausrichtungsmarke (M1, M2, M3, M4, M5) vorgenommenen Messungen abgeleitet wird,
**dadurch gekennzeichnet, dass** der eine oder die mehreren primären Ausrichtungsköpfe (AL1) mindestens zwei Ausrichtungsmarken (M1, M2, M3, M4, M5) in Übereinstimmung mit jedem von dem mindestens einen sekundären Ausrichtungskopf (AL21, AL22, AL23, AL24) messen.

2. Verfahren gemäß Anspruch 1, wobei alle Ausrichtungsmarken (M1, M2, M3, M4, M5) sowohl von dem primären Ausrichtungskopf (AL1) als auch von jedem der sekundären Ausrichtungsköpfe (AL21, AL22, AL23, AL24) gemessen werden.

3. Verfahren gemäß einem der vorhergehenden Ansprüche, wobei die Vielzahl von Messungen von den mehrfachen Ausrichtungsköpfen (AL1, AL21, AL22, AL23, AL24) parallel vorgenommen wird.

4. Verfahren gemäß Anspruch 3, wobei der Messschritt für jeden Messkopf (AL1, AL21, AL22, AL23, AL24) das In-Fokus-Bringen der Ausrichtungsmarkierung (M1, M2, M3, M4, M5) beinhaltet.

5. Ein Verfahren der Waferausrichtung, durchgeführt als Vorbereitung für einen lithographischen Vorgang, wobei der Wafer von einem Ausrichtungssystem gemessen wird, das ein primäres Ausrichtungssystem, beinhaltend einen primären Ausrichtungskopf (AL1), und ein sekundäres Ausrichtungssystem, beinhaltend einen oder mehrere sekundäre Ausrichtungsköpfe (AL21, AL22, AL23, AL24), beinhaltet; wobei das Verfahren Folgendes beinhaltet:
Durchführen einer primären Grundlininenkalibrierung zum Ausrichten des primären Ausrichtungskopfs (AL1) in Bezug auf ein Bezugsobjekt;
Durchführen einer sekundären Grundlininenkalibrierung zum Ausrichten der sekundären Ausrichtungsköpfe (AL21, AL22, AL23, AL24) in Bezug auf den primären Ausrichtungskopf (AL1); und
Kalibrieren eines oder mehrerer sekundärer Ausrichtungsköpfe (AL21, AL22, AL23, AL24) in Bezug auf den primären Ausrichtungskopf (AL1), wobei:
der primäre Ausrichtungskopf (AL1) eine Ausrichtungsmarke (M1, M2, M3, M4, M5) misst;
mindestens ein sekundärer Ausrichtungskopf (AL21, AL22, AL23, AL24) dieselbe Ausrichtungsmarke (M1, M2, M3, M4, M5) misst; und
die Versetzung des sekundären Ausrichtungskopfs (AL21, AL22, AL23, AL24) in Bezug auf den primären Ausrichtungskopf (AL1) aus den an dieser Ausrichtungsmarke (M1, M2, M3, M4, M5) vorgenommenen Messungen abgeleitet wird,
**dadurch gekennzeichnet, dass** der primäre Ausrichtungskopf (AL1) mindestens zwei Ausrichtungsmarken (M1, M2, M3, M4, M5) in Übereinstimmung mit jedem von dem mindestens einen sekundären Ausrichtungskopf (AL21, AL22, AL23, AL24) misst.

6. Verfahren gemäß Anspruch 5, wobei die Vielzahl von Messungen von den mehrfachen Ausrichtungsköpfen (AL1, AL21, AL22, AL23, AL24) parallel vorgenommen wird.

7. Verfahren gemäß Anspruch 6, wobei der Messschritt für jeden Messkopf (AL1, AL21, AL22, AL23, AL24) das In-Fokus-Bringen der Ausrichtungsmarkierung (M1, M2, M3, M4, M5) beinhaltet.

8. Eine Kalibrierungsvorrichtung, die Folgendes beinhaltet:
ein Ausrichtungssystem, das Folgendes beinhaltet:
ein primäres Ausrichtungssystem, das einen primären Ausrichtungskopf (AL1) und einen Sensor zum Detektieren einer Ausrichtungsmarke (M1, M2, M3, M4, M5) beinhaltet;
ein sekundäres Ausrichtungssystem, das einen oder mehrere sekundäre Ausrichtungsköpfe (AL21, AL22, AL23, AL24) beinhaltet, die jeweils einen Sensor zum Detektieren einer Ausrichtungsmarke (M1, M2, M3, M4, M5) beinhalten;
einen Mechanismus zum Bewegen des Ausrichtungssystems zwischen einer ersten Position, in der der primäre Ausrichtungskopf (AL1) eine Ausrichtungsmarke (M1, M2, M3, M4, M5) misst, und einer zweiten Position, in der ein sekundärer Ausrichtungskopf (AL21, AL22, AL23, AL24) dieselbe Ausrichtungsmarke (M1, M2, M3, M4, M5) misst;
einen Codierer (1000, 1002, 1004, 1006) zum Messen der Position des Ausrichtungssystems; und
einen Prozessor zum Empfangen von Messungen von den Ausrichtungssystemsensoren und Positionsinformationen von dem Mechanismus zum Bewegen des Ausrichtungssystems und Berechnen der Versetzung des sekundären Ausrichtungskopfs (AL21, AL22, AL23, AL24) in Bezug auf den primären Ausrichtungskopf (AL1) aus den Messungen,
**dadurch gekennzeichnet, dass** der Mechanismus dafür geeignet ist, den primären Ausrichtungskopf (AL1) zum Messen von mindestens zwei Ausrichtungsmarken (M1, M2, M3, M4, M5) in Übereinstimmung mit jedem von den sekundären Ausrichtungsköpfen (AL21, AL22, AL23, AL24) zu bewegen.

9. Eine lithographische Vorrichtung, die Folgendes beinhaltet:
eine Kalibrierungsvorrichtung, die Folgendes beinhaltet:
ein Ausrichtungssystem, das Folgendes beinhaltet:
ein primäres Ausrichtungssystem, das einen primären Ausrichtungskopf (AL1) und einen Sensor zum Detektieren einer Ausrichtungsmarke (M1, M2, M3, M4, M5) beinhaltet;
ein sekundäres Ausrichtungssystem, das einen oder mehrere sekundäre Ausrichtungsköpfe (AL21, AL22, AL23, AL24) beinhaltet, die jeweils einen Sensor zum Detektieren einer Ausrichtungsmarke (M1, M2, M3, M4, M5) beinhalten;
einen Mechanismus zum:
Bewegen des Ausrichtungssystems zwischen Messpositionen zum Durchführen einer primären Grundlinienkalibrierung zum Ausrichten des primären Ausrichtungskopfs (AL1) in Bezug auf ein Bezugsobjekt und einer sekundären Grundlinienkalibrierung zum Ausrichten der sekundären Ausrichtungsköpfe (AL21, AL22, AL23, AL24) in Bezug auf den primären Ausrichtungskopf (AL1);
und zum Bewegen des Ausrichtungssystems zwischen einer ersten Position, in der der primäre Ausrichtungskopf (AL1) eine Ausrichtungsmarke (M1, M2, M3, M4, M5) misst, und einer zweiten Position, in der ein sekundärer Ausrichtungskopf (AL21, AL22, AL23, AL24) dieselbe Ausrichtungsmarke (M1, M2, M3, M4, M5) misst;
einen Codierer (1000, 1002, 1004, 1006) zum Messen der Position des Ausrichtungssystems; und
einen Prozessor zum Empfangen von Messungen von den Ausrichtungssystemsensoren und Positionsinformationen von dem Mechanismus zum Bewegen des Ausrichtungssystems und Berechnen der Versetzung des sekundären Ausrichtungskopfs (AL21, AL22, AL23, AL24) in Bezug auf den primären Ausrichtungskopf (AL1) aus den Messungen,
**dadurch gekennzeichnet, dass** der Mechanismus dafür geeignet ist, den primären Ausrichtungskopf (AL1) zum Messen von mindestens zwei Ausrichtungsmarken (M1, M2, M3, M4, M5) in Übereinstimmung mit jedem von den sekundären Ausrichtungsköpfen (AL21, AL22, AL23, AL24) zu bewegen.

10. Lithographische Vorrichtung gemäß Anspruch 9, wobei die Vielzahl von Messungen von den mehrfachen Ausrichtungsköpfen (AL1, AL21, AL22, AL23, AL24) parallel vorgenommen wird.

11. Lithographische Vorrichtung gemäß Anspruch 10, die ferner einen Mechanismus zum In-Fokus-Bringen der oder jeder Ausrichtungsmarkierung (M1, M2, M3, M4, M5) beinhaltet.

## Revendications

1. Un procédé de calibrage d'une ou de plusieurs têtes d'alignement secondaires (AL21, AL22, AL23, AL24) avec une ou plusieurs têtes d'alignement primaires (AL1), dans lequel
la tête d'alignement primaire (AL1) mesure un repère d'alignement (M1, M2, M3, M4, M5) ;
au moins une tête d'alignement secondaire (AL21, AL22, AL23, AL24) mesure le même repère d'alignement (M1, M2, M3, M4, M5) ; et
le décalage de la tête d'alignement secondaire (AL21, AL22, AL23, AL24) par rapport à la tête d'alignement primaire (AL1) est dérivé des mesures réalisées sur ce repère d'alignement (M1, M2, M3, M4, M5),
**caractérisé en ce que** ces une ou plusieurs têtes d'alignement primaires (AL1) mesurent au moins deux repères d'alignement (M1, M2, M3, M4, M5) en commun avec chacune de cette au moins une tête d'alignement secondaire (AL21, AL22, AL23, AL24).

2. Le procédé de la revendication 1, dans lequel les repères d'alignement (M1, M2, M3, M4, M5) sont tous mesurés à la fois par la tête d'alignement primaire (AL1) et chacune des têtes d'alignement secondaires (AL21, AL22, AL23, AL24).

3. Le procédé de n'importe quelle revendication précédente, dans lequel la pluralité de mesures sont réalisées en parallèle par les têtes d'alignement multiples (AL1, AL21, AL22, AL23, AL24).

4. Le procédé de la revendication 3, dans lequel l'étape de mesure comprend, pour chaque tête de mesure (AL1, AL21, AL22, AL23, AL24), le fait de mettre le repère d'alignement (M1, M2, M3, M4, M5) au point.

5. Un procédé d'alignement de tranche, exécuté en préparation d'un procédé lithographique, dans lequel la tranche est mesurée par un système d'alignement qui comprend un système d'alignement primaire comprenant une tête d'alignement primaire (AL1) et un système d'alignement secondaire comprenant une ou plusieurs têtes d'alignement secondaires (AL21, AL22, AL23, AL24) ; le procédé comprenant l'exécution d'un calibrage de ligne de base primaire afin d'aligner la tête d'alignement primaire (AL1) par rapport à un objet de référence ;
l'exécution d'un calibrage de ligne de base secondaire afin d'aligner les têtes d'alignement secondaires (AL21, AL22, AL23, AL24) par rapport à la tête d'alignement primaire (AL1) ; et
le calibrage d'une ou de plusieurs têtes d'alignement secondaires (AL21, AL22, AL23, AL24) par rapport à la tête d'alignement primaire (AL1), dans lequel :
la tête d'alignement primaire (AL1) mesure un repère d'alignement (M1, M2, M3, M4, M5) ;
au moins une tête d'alignement secondaire (AL21, AL22, AL23, AL24) mesure le même repère d'alignement (M1, M2, M3, M4, M5) ; et
le décalage de la tête d'alignement secondaire (AL21, AL22, AL23, AL24) par rapport à la tête d'alignement primaire (AL1) est dérivé des mesures réalisées sur ce repère d'alignement (M1, M2, M3, M4, M5),
**caractérisé en ce que** la tête d'alignement primaire (AL1) mesure au moins deux repères d'alignement (M1, M2, M3, M4, M5) en commun avec chacune de cette au moins une tête d'alignement secondaire (AL21, AL22, AL23, AL24).

6. Le procédé de la revendication 5, dans lequel la pluralité de mesures sont réalisées en parallèle par les têtes d'alignement multiples (AL1, AL21, AL22, AL23, AL24).

7. Le procédé de la revendication 6, dans lequel l'étape de mesure comprend, pour chaque tête de mesure (AL1, AL21, AL22, AL23, AL24), le fait de mettre le repère d'alignement (M1, M2, M3, M4, M5) au point.

8. Appareil de calibrage comprenant
un système d'alignement comprenant
un système d'alignement primaire comprenant une tête d'alignement primaire (AL1) et un capteur pour détecter un repère d'alignement (M1, M2, M3, M4, M5) ; un système d'alignement secondaire comprenant une ou plusieurs têtes d'alignement secondaires (AL21, AL22, AL23, AL24), chacune comprenant un capteur pour détecter un repère d'alignement (M1, M2, M3, M4, M5) ;
un mécanisme pour déplacer le système d'alignement entre une première position dans laquelle la tête d'alignement primaire (AL1) mesure un repère d'alignement (M1, M2, M3, M4, M5) ; et une deuxième position dans laquelle une tête d'alignement secondaire (AL21, AL22, AL23, AL24) mesure le même repère d'alignement (M1, M2, M3, M4, M5) ;
un encodeur (1000, 1002, 1004, 1006) pour mesurer la position du système d'alignement ; et
un processeur pour recevoir des mesures provenant des capteurs de système d'alignement et des informations de position provenant du mécanisme pour déplacer le système d'alignement ; et calculer d'après les mesures le décalage de la tête d'alignement secondaire (AL21, AL22, AL23, AL24) par rapport à la tête d'alignement primaire (AL1),
**caractérisé en ce que** le mécanisme convient pour déplacer la tête d'alignement primaire (AL1) afin de mesurer au moins deux repères d'alignement (M1, M2, M3, M4, M5) en commun avec chacune des têtes d'alignement secondaires (AL21, AL22, AL23, AL24).

9. Un appareil lithographique comprenant
l'appareil de calibrage comprenant
un système d'alignement comprenant
un système d'alignement primaire comprenant une tête d'alignement primaire (AL1) et un capteur pour détecter un repère d'alignement (M1, M2, M3, M4, M5) ; un système d'alignement secondaire comprenant une ou plusieurs têtes d'alignement secondaires (AL21, AL22, AL23, AL24), chacune comprenant un capteur pour détecter un repère d'alignement (M1, M2, M3, M4, M5) ;
un mécanisme pour :
déplacer le système d'alignement entre des positions de mesure pour exécuter un calibrage de ligne de base primaire afin d'aligner la tête d'alignement primaire (AL1) par rapport à un objet de référence, et un calibrage de ligne de base secondaire afin d'aligner les têtes d'alignement secondaires (AL21, AL22, AL23, AL24) par rapport à la tête d'alignement primaire (AL1) ;
et pour déplacer le système d'alignement entre une première position dans laquelle la tête d'alignement primaire (AL1) mesure un repère d'alignement (M1, M2, M3, M4, M5) ; et une deuxième position dans laquelle une tête d'alignement secondaire (AL21, AL22, AL23, AL24) mesure le même repère d'alignement (M1, M2, M3, M4, M5) ;
un encodeur (1000, 1002, 1004, 1006) pour mesurer la position du système d'alignement ; et
un processeur pour recevoir des mesures provenant des capteurs de système d'alignement et des informations de position provenant du mécanisme pour déplacer le système d'alignement ; et calculer d'après les mesures le décalage de la tête d'alignement secondaire (AL21, AL22, AL23, AL24) par rapport à la tête d'alignement primaire (AL1),
**caractérisé en ce que** le mécanisme convient pour déplacer la tête d'alignement primaire (AL1) afin de mesurer au moins deux repères d'alignement (M1, M2, M3, M4, M5) en commun avec chacune des têtes d'alignement secondaires (AL21, AL22, AL23, AL24).

10. L'appareil lithographique de la revendication 9, dans lequel la pluralité de mesures sont réalisées en parallèle par les têtes d'alignement multiples (AL1, AL21, AL22, AL23, AL24).

11. L'appareil lithographique de la revendication 10, comprenant en sus un mécanisme pour mettre le ou chaque repère d'alignement (M1, M2, M3, M4, M5) au point.
